(19) Europäisches Patentamt
European Patent Office
Office européen des brevets

(11) **EP 2 649 614 B1**

(12) **EUROPEAN PATENT SPECIFICATION**

(45) Date of publication and mention of the grant of the patent:
**04.11.2015 Bulletin 2015/45**

(21) Application number: **11799394.9**

(22) Date of filing: **09.12.2011**

(51) Int Cl.:
***H03H 17/06*** *(2006.01)* ***G10L 19/26*** *(2013.01)*

(86) International application number:
**PCT/EP2011/072311**

(87) International publication number:
**WO 2012/076689 (14.06.2012 Gazette 2012/24)**

(54) **PSYCHOACOUSTIC FILTER DESIGN FOR RATIONAL RESAMPLERS**

PSYCHOAKUSTISCHE FILTERGESTALTUNG FÜR RATIONALE RESAMPLER

CONCEPTION DE FILTRE PSYCHO-ACOUSTIQUE POUR DES RÉÉCHANTILLONNEURS RATIONNELS

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **09.12.2010 US 421271 P**

(43) Date of publication of application:
**16.10.2013 Bulletin 2013/42**

(73) Proprietor: **Dolby International AB**
**1101 CN Amsterdam Zuid-Oost (NL)**

(72) Inventor: **SCHILDBACH, Wolfgang**
**90429 Nuernberg (DE)**

(74) Representative: **Dolby International AB**
**Patent Group Europe**
**Apollo Building, 3E**
**Herikerbergweg 1-35**
**1101 CN Amsterdam Zuidoost (NL)**

(56) References cited:
**EP-A1- 1 622 264** **US-A- 5 222 189**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

EP 2 649 614 B1

## Description

TECHNICAL FIELD

The present document relates to the design of anti-aliasing and/or anti-imaging filters for resamplers using rational resampling factors. In particular, the present document relates to a method for designing such filters having a reduced number of filter coefficients or an increased perceptual performance, as well as to the filters designed using such a method.

BACKGROUND

Different audio formats may require different sampling rates (e.g. 32 kHz, 44.1 kHz or 48 kHz). In order to transfer an audio signal at a first sampling rate (e.g. at 32 kHz) to an audio signal at a second sampling rate (e.g. at 48 kHz) rational resamplers may be used. The resampling of audio by rational factors typically introduces imaging/aliasing artifacts into the resampled audio signal. An anti-imaging/anti-aliasing filter may be used to suppress the unwanted images and/or aliases of the audio signal. The present document describes anti-imaging / anti-aliasing filters used in rational resamplers. Furthermore, the present document describes a method for designing such anti-imaging / anti-aliasing filters. In particular, filter design methods (and resulting filters) are described which take into account psychoacoustic constraints, in order to provide filters having a reduced number of filter coefficients, while providing subjectively unchanged or similar audio quality of the resampled audio signal. Vice versa, the filter design methods may be used to design filters with a given number of filter coefficients, which provide an improved audio quality compared to filters designed in accordance to conventional filter design methods.

As a consequence of designing improved anti-imaging / anti-aliasing filters, the complexity of rational resamplers may be decreased, while maintaining a given subjective audio quality Vice versa, the audio quality of the rational resamplers may be increased, while maintaining the rational resamplers at a given computational complexity.

European patent application published under number EP 1 622 264 describes a sampling rate converter having a processing unit with a transmission function associated with a transmission function of a pre-filter and a transmission function of an equalizer.

US patent published under number US 5,222,189 describes encoders/decoders having a short signal-propagation delay in which residual distortion is masked.

SUMMARY

According to the claims a method for designing a filter, e.g. an anti-aliasing and/or anti-imaging filter, is described. The filter may be a digital filter comprising a set of filter coefficients. In the following, the filter will be referred to as anti-aliasing filter (even though the filter may also remove imaging effects). The resulting filter may be configured to reduce imaging and/or aliasing of an output audio signal at an output sampling rate $fs_{out}$. The output audio signal is a resampled version of an input audio signal at an input sampling rate $fs_{in}$. The ratio of the output sampling rate $fs_{out}$ and the input sampling rate $fs_{in}$ is a rational number N/M, wherein N > 0, M > 0. Without loss of generality, N and M should be mutually prime. In an embodiment, neither N, nor Mare equal to 1, meaning that the resampler is neither a pure upsampler by an integer factor N, nor a pure downsampler by an integer factor M. In other words, the resampler comprises an upsampling component by a factor N>1, and a downsampling component by a factor M>1. In yet other words, the fraction N/M may not be an integer value, and the fraction M/N may not be an integer value. By way of example, for $fs_{in}$=40kHz, $fs_{out}$=48kHz, N=6, M=5; or for $fs_{in}$=32kHz, $fs_{out}$=48kHz, N=3, M=2; or for $fs_{in}$=44.1kHz, $fs_{out}$=48kHz, N=160, M=147; or for $fs_{in}$=32kHz, $fs_{out}$=44.1kHz, N=441, M=320; or vice versa, i.e. for $fs_{in}$=48kHz, $fs_{out}$=40kHz, N=5, M=6; or for $fs_{in}$=48kHz, $fs_{out}$=32kHz, N=2, M=3; or for $fs_{in}$=48kHz, $fs_{out}$=44.1kHz, N=147, M=160; or for $fs_{in}$=44.1kHz, $fs_{out}$=32kHz, N=320, M=441.

The filter may be operated at an upsampled sampling rate which equals N times the input sampling rate $fs_{in}$. The upsampled sampling rate also equals M times the output sampling rate $fs_{out}$.

The method for designing the filter according to the claims may comprise the step of selecting a pass band edge of the frequency response of the filter. The selection of the pass band edge may comprise the selection of the frequency interval of the pass band. Frequencies smaller than the pass band edge are comprised within the pass band. The method may comprise the step of selecting a stop band edge of the frequency response of the filter. The selection of the stop band edge may comprise the selection of the frequency interval of the stop band. Frequencies greater than the stop band edge are comprised within the stop band.

The method may comprise the step of selecting an allowed deviation of the frequency response of the filter within the stop band. The allowed deviation indicates a deviation of the frequency response of the filter from a predetermined attenuation within the stop band. Typically, the predetermined attenuation of the filter within the stop band is 0 (i.e. - inf dB). As such, the allowed deviation may specify the tolerable deviation of the stop band attenuation from the ideal stop band attenuation at the predetermined value 0. In other words, a target frequency response of the filter may be determined. The target frequency response may specify a pass band attenuation (e.g. a value of 1 or 0dB), a stop band attenuation (e.g. a value of 0 or -inf dB), a pass band edge and/or a stop band edge. The allowed deviation may be the allowed deviation of the frequency response of the filter from the target frequency response.

The resulting filter may be a low pass filter with a pass band covering a frequency interval in the frequency range of 0kHz to the pass band edge. In such a case, the stop band of the resulting filter would cover the frequency interval above the stop band edge, wherein the stop band edge corresponds to a higher frequency than the pass band edge.

The allowed deviation of the frequency response of the filter within the stop band may be selected based on a perceptual frequency response indicative of an auditory spectral sensitivity. The perceptual frequency response may indicate the sensitivity of an average listener to particular frequencies of an audio signal. In other words, the perceptual frequency response may indicate how well certain frequencies of an audio signal are perceived by a listener. The perceptual frequency response may be associated with a first perceptual frequency response. The first perceptual frequency response may correspond to or may be indicative of a scaled version of an absolute threshold of hearing curve. The scaling may depend on the desired degree of rejection of the stop band. In particular, the absolute threshold of hearing (ATH) curve may be scaled such that the lowest absolute threshold of the ATH curve or an average value of the scaled ATH curve corresponds to a pre-determined degree of attenuation (e.g. -90dB) of the target frequency response.

The step of selecting an allowed deviation of the frequency response of the filter within the stop band may comprise the step of selecting the allowed deviation based on images and/or mirrored images of the first perceptual frequency response. Images of the first perceptual frequency response may be copies of the first perceptual frequency response, possibly transposed to other frequency intervals. Mirrored images of the first perceptual frequency response may be mirrored versions of the first perceptual frequency response, possibly transposed to other frequency intervals. Typically, the images and/or mirrored images are transposed or shifted by the output sampling rate and/or a multiple thereof.

As indicated above, the resulting filter may be operated at an upsampled sampling rate $M * fs_{out}$. As such, a spectrum of the (upsampled) output audio signal may cover a frequency range from 0 to $M * fs_{out} / 2$. As a result of a downsampling operation by the factor M generating the output audio signal, a portion of the spectrum covering the frequency range $[(m-1)*fs_{out}/2,(m+1)*fs_{out}/2]$ for m=2,4,...,M, may be shifted to the baseband $[-fs_{out} / 2,+fs_{out} / 2]$, thereby creating aliasing artifacts in the output audio signal. These artifacts are perceived by a human listener in accordance to an auditory spectral sensitivity reflected in the perceptual frequency response.

In order to reflect the shifting of high frequency ranges into the baseband, the first perceptual frequency response covering a frequency range of $[0, +fs_{out} / 2]$, as well as a mirrored image of the first perceptual frequency response covering a frequency range of $[-fs_{out} / 2,0]$ may be shifted to the frequency ranges $[(m-1)* fs_{out} / 2,(m+1)* fs_{out} / 2]$ for m=2,4,...,M, thereby creating the images and/or mirrored images of the first perceptual frequency response. These images and/or mirrored images are symmetrical with respect to a frequency derived from the output sampling rate $fs_{out}$. In particular, these images and/or mirrored images are symmetrical with respect to the output sampling rate $fs_{out}$ and/or a multiple thereof. In other words, some of these images and/or mirrored images may be symmetrical with respect to a symmetry axis corresponding to the output sampling rate $fs_{out}$ and/or a multiple thereof.

As such, the first perceptual frequency response may cover a frequency interval from 0kHz to half the output sampling rate (i.e. $[0, +fs_{out} / 2]$) or a part of this frequency interval. Furthermore, a baseband mirrored image of the first perceptual frequency response (i.e. a mirrored image of the first perceptual frequency response in the baseband, mirrored along the symmetry axis at 0kHz) may cover a frequency interval from 0kHz to minus half the output sampling rate (i.e. $[-fs_{out} / 2,0]$) or a part of this latter frequency interval.

The images of the first perceptual frequency response which are used for the selection of the allowed deviation of the frequency response of the filter within the stop band may correspond to the first perceptual frequency response and/or the baseband mirrored image of the first perceptual frequency response shifted by the output sampling rate and/or a multiple thereof.

The selection of the allowed deviation of the frequency response of the filter within the stop band may comprise the step of setting the allowed deviation within a given frequency interval equal to the images of the first perceptual frequency response (and/or its baseband mirrored image) within the given frequency interval. In other words, the allowed deviation of the frequency response within a given frequency interval may be set equal to the images and/or mirrored images of the first perceptual frequency response within the given frequency interval. The given interval may correspond to the frequency intervals within the stop band outside the "don’t care" intervals specified below.

The perceptual frequency response may be associated with a second perceptual frequency response. The second perceptual frequency response may comprise a scaled relative masking threshold curve indicative of the masking by a neighbouring masker frequency. In other words, the second perceptual frequency response may reflect the fact that a signal at a masker frequency masks signals at frequencies within the vicinity of the masker frequency. The relative masking threshold curve may indicate the threshold of hearing a frequency in the vicinity of the masker frequency. Due the masking effect of the masker frequency, the threshold of hearing may be increased in the vicinity of the masker frequency.

As a result of an upsampling operation, images of a baseband masker frequency may be created in the intermediate, i.e. upsampled, frequency domain. Some of these images may be aliased back to the baseband masker frequency during the downsampling operation. The images of the baseband masker frequency in the intermediate frequency domain which meet this condition may be referred to as maskee frequencies as their aliases may be masked by the baseband masker frequency. In other words, the baseband masker frequency (and/or the maskee frequency) may meet the self masking condition that the maskee frequency in the intermediate frequency domain corresponds to a baseband masker frequency of the input audio signal in the frequency range of [-$fs_{in}$/2, $fs_{in}$/2] shifted by $fs_{in}$ or a multiple thereof; and that the maskee frequency aliases to the output audio signal at plus and/or minus the baseband masker frequency.

The baseband masker frequency may meet the condition that the absolute value of the baseband masker frequency corresponds to the absolute value of (n * $fs_{in}$/2 - m * $fs_{out}$/2), for at least some of n=1,...,N and m=1,...,M. In other words, for the baseband masker frequencies the condition

$$|f| = |n \cdot fs_{in} / 2 - m \cdot fs_{out} / 2|, with\ n = 1,...,N, m = 1,...,M\ ,$$

may be met for at least some of the possible values of n and m. In a similar manner, the maskee frequency in the intermediate frequency domain may correspond to n * $fs_{in}$/2+ m * $fs_{out}$/2, for at least some of n=-N,...,N and m=-M,...,M, i.e. the maskee frequency may meet the condition

$$f = n \cdot fs_{in} / 2 + m \cdot fs_{out} / 2, with\ n = -N,...,N, m = -M,...,M\ ,$$

for at least some of the possible values of n and m.

The above self masking conditions may be used to identify one or more maskee frequencies in the intermediate domain and one or more corresponding masker frequencies in the baseband. The one or more maskee frequencies meeting the self masking condition may correspond to a maximum of a scaled relative masking threshold curve. I.e. for these maskee frequencies the masking caused by the baseband masker frequency may be maximal. In addition, if a frequency in the intermediate domain approximately fulfills the above condition, then the alias of this frequency will typically be close to the baseband masker frequency, and can be subject to masking by that baseband masker frequency. This masking of frequencies in the vicinity of the maskee frequencies in the intermediate domain may be modeled by the progression of the scaled relative masking threshold curve.

In an embodiment, the second perceptual frequency response comprises a scaled relative masking threshold curve for each maskee frequency meeting the self masking condition. The overall perceptual frequency response used for the determination of the allowed deviations of the frequency response may correspond to a combination, e.g. a maximum, of the first perceptual frequency response and the second perceptual frequency response.

The step of selecting the allowed deviation of the frequency response of the filter within the stop band may comprise the step of partitioning the stop band into a plurality of frequency intervals comprising one or more "don't care" intervals. The allowed deviation may take on arbitrary or undefined values within a "don't care" interval. In other words, the allowed deviation of the frequency response may be unconstrained or undefined within a "don't care" interval. The one or more "don't care" intervals may comprise one or more first "don't care" intervals associated with frequencies for which a spectrum of the input audio signal is below a pre-determined input energy threshold. By way of example, the input audio signal may be bandwidth limited to a frequency fx lower than the Nyquist frequency $fs_{in}$/2. As a result, the spectrum of the input audio signal may be below the input energy threshold in the frequency interval [fx,$fs_{in}$/2] (as well as in the mirrored frequency interval [-$fs_{in}$/2,-fx]. The one or more first "don't care" intervals may be associated with the frequencies of the frequency interval [fx,$fs_{in}$/2] (as well as with the frequencies of the mirrored frequency interval [-$fs_{in}$/2,-fx]).

The one or more first "don't care" intervals may be symmetrical with respect to a frequency derived from the input sampling rate $fs_{in}$. In particular, the one or more first "don't care" intervals may be symmetrical with respect to the input sampling rate $fs_{in}$ and/or a multiple thereof. In the above example, the frequency interval [fx,$fs_{in}$/2], as well as the mirrored image [-$fs_{in}$/2,-fx] may constitute first "don't care" intervals associated with the input audio signal. As a result of the up-by-N upsampling operation, further images and mirrored images of these first "don't care" intervals may be created at frequency intervals [fx+n* $fs_{in}$,$fs_{in}$/2+n* $fs_{in}$], as well as [-$fs_{in}$/2+n* $fs_{in}$,-fx+n* $fs_{in}$], for n=1,...,N/2. These further images and mirrored images may also constitute first "don't care" intervals. As a result of the shift operation by $fs_{in}$ some

of the first "don't care" intervals are symmetrical with respect to the input sampling rate $fs_{in}$ and/or a multiple thereof.

The one or more "don't care" intervals may comprise one or more second "don't care" intervals associated with frequencies for which the perceptual frequency response exceeds a pre-determined perceptual threshold. The one or more second "don't care" intervals may correspond to frequencies for which the images and/or mirrored images of the perceptual frequency response exceed the pre-determined perceptual threshold. The perceptual frequency response may take on values indicating a low auditory spectral sensitivity for certain frequency intervals. If the perceptual frequency response exceeds the pre-determined perceptual threshold, i.e. if the perceptual frequency response indicates an auditory sensitivity lying below a pre-determined sensitivity threshold, it may be beneficial to remove any constraints on the target frequency response, thereby increasing the degrees of freedom for the filter design. As such, further "don't care" intervals (i.e. the second "don't care" intervals) may be defined.

As indicated above, the method may comprise the step of selecting a pass band edge and/or a stop band edge of the frequency response of the filter. The pass band edge and/or the stop band edge may be based on the lower one of the input sampling rate $fs_{in}$ and the output sampling rate $fs_{out}$. In particular, the pass band edge and/or the stop band edge may be set to the lower one of the Nyquist rate $fs_{in}/2$ of the input audio signal and the Nyquist rate $fs_{out}/2$ of the output audio signal. Alternatively or in addition, the pass band edge and/or the stop band edge may be selected based on the bandwidth of the input audio signal. The pass band is positioned at frequencies lower than the pass band edge, and the stop band is positioned at frequencies higher than the stop band edge.

The method may comprise the step of determining coefficients of the filter such that the frequency response of the filter is fitted to the allowed deviation of the frequency response. The step of determining coefficients of the filter may comprise the step of fitting the frequency response of the filter to the allowed deviation using a maximum absolute difference criteria or a least mean square criteria. In particular, the coefficients of the filter may be determined using a Remez exchange algorithm or Parks-McClellan algorithm.

The Parks-McClellan algorithm minimizes the maximum of an approximation error function, wherein the approximation error function is based on the different between the frequency response of the filter and the predetermined attenuation within the stop band. Typically, the approximation error function is weighted. The weights may be proportional to the inverse of the allowed deviation of the frequency response of the filter.

In an embodiment, the step of determining coefficients of the filter comprises the step of fitting the frequency response of the filter to the allowed deviation of the frequency response outside of the one or more "don't care" intervals. As indicated above, the allowed deviation may take on arbitrary or undefined values within the one or more "don't care" intervals. As such, the fitting to the frequency response to the allowed deviation may be performed by imposing no constraints on the frequency response of the filter within the one or more "don't care" intervals. In the context of the Parks-McClellan algorithm, the "don't care" intervals may be taken into account by ignoring the approximation error function within the "don't care" intervals. In other words, the maximum approximation error function would not be minimized within the "don't care" intervals.

The method may comprise the step of selecting an allowed deviation of the frequency response of the filter within the pass band. The allowed deviation may indicate the deviation of the magnitude of the frequency response from a predetermined pass band attenuation, which is typically 1 (i.e. 0 dB). The allowed deviation may be a fixed, i.e. frequency independent, allowed deviation within the pass band.

According to further aspect a filter is described, wherein the filter may be designed in accordance to the design method and any related feature outlined in the present document.

According to another aspect a filter is described, wherein the filter is configured to reduce imaging and/or aliasing of an output audio signal at an output sampling rate $fs_{out}$. The output audio signal may be a resampled version of an input audio signal at an input sampling rate $fs_{in}$. The ratio of the output sampling rate $fs_{out}$ and the input sampling rate $fs_{in}$ may be a rational number N/M, as outlined above. The filter may operate at an upsampled sampling rate which equals N times the input sampling rate $fs_{in}$. As indicated above, the upsampled sampling rate may also be equal to M times the output sampling rate $fs_{out}$. The filter may comprise a pass band and a stop band. Furthermore, the filter may have a have a pass band edge and/or a stop band edge (or a cut off frequency) based on the lower one of the input sampling rate and the output sampling rate.

The frequency response of the filter within the stop band may be associated with a perceptual frequency response indicative of an auditory spectral sensitivity. As outlined above, the perceptual frequency response may be associated with a first frequency response comprising a scaled and/or shifted version of the absolute threshold of hearing (ATH) curve. In particular, the frequency response of the filter within the stop band may be associated with images and/or mirrored images of the first perceptual frequency response. These images and/or mirrored images may be symmetrical with respect to a frequency derived from the output sampling rate $fs_{out}$. As such, the frequency response of the filter within the stop band may be associated with the first perceptual frequency response covering a frequency interval of [0, $+fs_{out} / 2$], as well as a mirrored image of the first perceptual frequency response covering a frequency interval of [$-fs_{out} / 2$, 0]. In particular, the frequency response of the filter within the stop band may be associated with images of these first perceptual frequency responses centered at the output sampling rate $fs_{out}$ and/or multiples thereof, i.e. images at

$[(m-1)^* fs_{out} / 2,(m+1)^* fs_{out} / 2]$ for m=2,4,...,M.

Alternatively or in addition the frequency response in the stop band may be associated with a second perceptual frequency response comprising a scaled relative masking threshold curve indicative of the masking (by a masker frequency) of neighbouring frequencies. In particular, the overall perceptual frequency response may be a combination of the first and second perceptual frequency response.

The frequency response of the filter may be fitted to the perceptual frequency response using a maximum absolute difference criteria. In an embodiment, the frequency response of the filter does not exceed the perceptual frequency response within selected frequency intervals, e.g. frequency intervals outside of the above mentioned "don't care" intervals. In other words, the attenuation of the filter may not exceed the attenuation defined by the perceptual frequency response within selected frequency intervals.

According to a further aspect, a method for resampling an input audio signal at an input sampling rate $fs_{in}$ to an output audio signal at an output sampling rate $fs_{out}$ is described. The ratio of the output sampling rate $fs_{out}$ and the input sampling rate $fs_{in}$ may be a rational number N/M. The method may comprise the step of providing a set of coefficients of a filter. The filter may be any filter described in the present document, e.g. any filter designed according to a method outlined in the present document. The method may proceed in selecting a first subset of coefficients from the set of coefficients. This first subset may comprise a first coefficient of the set and additional coefficients of the set following the first coefficient by multiples of N. In other words, every $N^{th}$ coefficient (starting from the first coefficient) of the set of coefficients may be selected for the first subset of coefficients.

The method may further comprise the step of determining a first sample of the output audio signal based on the first subset of coefficients and a first plurality of samples of the input audio signal. In other words, a first sample of the output audio signal may be determined by filtering a first plurality of samples of the input audio signal using a filter based on the first subset of coefficients.

In order to determine a second sample of the output audio signal, the method may comprise the step of selecting a second coefficient of the set based on the first coefficient and M. The method may proceed in selecting a second subset of coefficients from the set of coefficients, wherein the second subset comprises the second coefficient and coefficients of the set following the second coefficient by multiples of N. In other words, the method may proceed in selecting a second subset comprising a shifted subset of filter coefficients. Finally, the method may determine the second sample of the output audio signal directly following the first sample, based on the second subset of coefficients and a second plurality of samples of the input audio signal.

In other words, the samples of the output audio signal may be determined using a polyphase finite impulse response implementation of the psychoacoustic filter described in the present document.

According to another aspect a resampler configured to generate an output audio signal at an output sampling rate $fs_{out}$ from an input audio signal at an input sampling rate $fs_{in}$ is described. The ratio of the output sampling rate $fs_{out}$ and the input sampling rate $fs_{in}$ may be a rational number N/M. The resampler may comprise a filter according to any of the aspects outlined in the present document. The filter comprises a set of coefficients. Furthermore, the resampler may comprise a coefficient selection unit configured to select a subset of coefficients from the set of coefficients. The selection of the subset may be performed as outlined above in the context of the first and/or second subset. In addition, the resampler may comprise a filtering unit configured to generate a sample of the output audio signal from a plurality of samples of the input audio signal using the subset of coefficients.

According to a a further aspect, a software program is described. The software program may be adapted for execution on a processor and for performing the aspects and features outlined in the present document when carried out on a computing device.

According to another aspect; a storage medium comprising a software program is described. The software program may be adapted for execution on a processor and for performing the aspects and features outlined in the present document when carried out on a computing device.

According to a further aspect, a computer program product is described. The computer program product may comprise executable instructions for performing the aspects and features outlined in the present document when executed on a computer.

It should be noted that the methods and systems including its preferred embodiments as outlined in the present document may be used stand-alone or in combination with the other methods and systems disclosed in this document. Furthermore, all aspects of the methods and systems outlined in the present document may be arbitrarily combined. In particular, the features of the claims may be combined with one another in an arbitrary manner.

## SHORT DESCRIPTION OF THE FIGURES

The methods and systems described in the present document are explained below in an exemplary manner with reference to the accompanying drawings, wherein

Fig. 1 illustrates a conceptual diagram of an example resampler;

Fig. 2 depicts a spectrum of an example upsampled input audio signal comprising two sinusoids;

Fig. 3 shows a bifrequency map indicating the imaging / aliasing contributions of example signals;

Fig. 4a illustrates example frequency intervals of an input audio signal not contributing to imaging / aliasing;

Fig. 4b shows an example target frequency response and an example frequency response of an anti-imaging / anti-aliasing filter;

Fig. 5a depicts an example absolute threshold of hearing curve;

Fig. 5b shows frequency intervals of an example output audio signal, wherein signal components of the output audio signal in the illustrated frequency intervals are not perceived by a human listener;

Fig. 5c shows an example target frequency response and an example frequency response of an anti-imaging / anti-aliasing filter taking into account psychoacoustic aspects;

Fig. 6 illustrates a comparison of example frequency responses of anti-imaging / anti-aliasing filters which do and do not take into account psychoacoustic aspects while having the same number of coefficients;

Fig. 7 illustrates an example spectrum of a resampled audio signal comprising a sinusoid at varying frequencies;

Fig. 8 shows an example triangle wave function used to illustrate imaging subject to upsampling;

Fig. 9 illustrates an example bifrequency map highlighting self-masking points;

Fig. 10 shows an example frequency response of a psychoacoustic upsampling filter;

Fig. 11a illustrates a mapping of a linear frequency scale to the Bark scale;

Fig. 11b illustrates an example self-masking threshold curve;

Fig. 11c illustrates the allowed deviations of an example resampling filter, due to self-masking and due to absolute threshold of hearing;

Fig. 12 shows an example frequency response of a psychoacoustic filter which takes into account the absolute threshold of hearing and the self-masking threshold; and

Fig. 13 shows a block diagram of an example method for designing a psychoacoustic filter for the resampling of audio signals.

DETAILED DESCRIPTION OF THE FIGURES

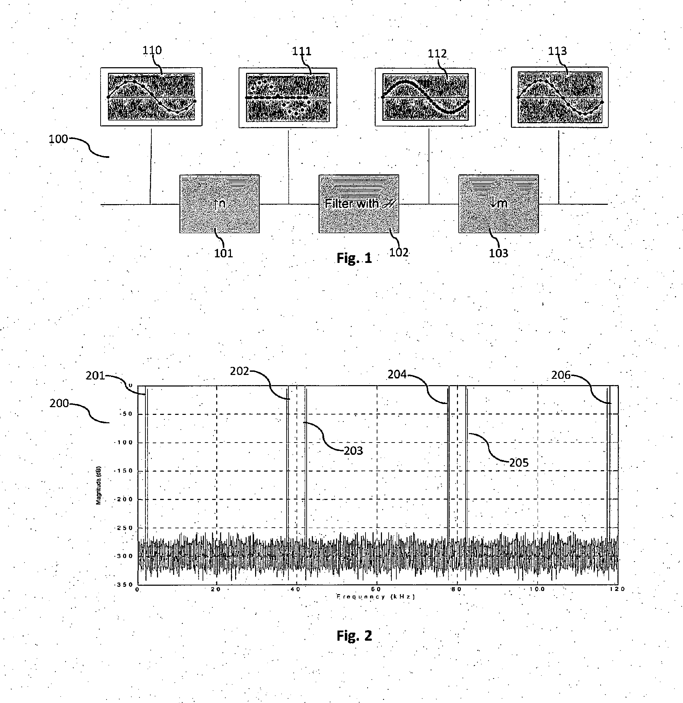

Fig. 1 illustrates conceptually a rational resampler 100. The rational resampler 100 comprises an up-by-N upsampler 101 which converts a sample of an input audio signal 110 into N samples of an upsampled audio signal 111. This may be achieved by inserting N-1 zeros between two samples of the input audio signal 110. Subsequently, the upsampled audio signal is filtered by an anti-aliasing/anti-imaging filter 102 with transfer function H(z). This results in a filtered audio signal 112. Finally, the filtered audio signal 112 is passed to a down-by-M decimator or downsampler 103 which only retains every $M^{th}$ sample of the filtered audio signal 112, to thereby provide the resampled (or output) audio signal 113. In case of a resampling of an input audio signal 110 at a sampling rate of 32 kHz to an output audio signal 113 at a sampling rate of 48 kHz, N is 3 and M is 2. In case of a resampling of an input audio signal 110 at a sampling rate of 44.1 kHz to an output audio signal 113 at a sampling rate of 48 kHz, N is 160 while M is 147.

It should be noted that the filter 102 runs at an intermediate frequency (IF) at N times the input sampling rate or at M times the output sampling rate (e.g. IF=M*48 kHz for the above mentioned cases). This means that the anti-aliasing filters 102 typically operate at high sampling rates, such that a reduction of the number of computational filter operations is desirable. In other words, it is desirable to reduce the number of required coefficients of the anti-aliasing filter 102, in order to reduce the overall computational complexity of the rational resampler 100.

The filters may be realized as a polyphase FIR (Finite Impulse Response) implementation. Such an implementation exploits the fact that the upsampled audio signal 111 which is filtered by filter 102 comprises N-1 zeros between the samples of the input audio signal 110. Consequently, the "zero" multiplications and additions can be omitted. Furthermore, a polyphase implementation exploits the fact that due to the subsequent down-by-M decimator 103, only every $M^{th}$ sample of the filtered audio signal 112 needs to be determined. By exploiting this information during the filter implementation, the number of multiplication and/or adding operations can be significantly reduced, thereby reducing the computational complexity of the rational resampler 100. Nevertheless, it is desirable to further reduce the computational complexity or to further improve the perceptual performance of the resampler 100.

As indicated above, the resampling operation creates imaging and/or aliasing artifacts in the output audio signal 113 if no anti-aliasing filter 102 is used. These imaging and/or aliasing artifacts are created as a result of the upsampling 101 and downsampling 103 operations. This is illustrated in the frequency spectrum shown in Fig. 2, where the spectrum 200 of an example input audio signal 110 at an input sampling rate or sampling frequency $fs_{in}$=40 kHz is depicted subsequent to upsampling 101 by a factor N=6. The original input audio signal 110 comprises two sinusoids 201 at 2 and 3 kHz, respectively. It can be seen that as a result of the upsampling operation 101, various images 202,..., 206 of the two sinusoids 201 have been created in the spectrum of the upsampled audio signal 111.

The input audio signal 110 has an input sampling rate $fs_{in}$=40 kHz, i.e. the Nyquist frequency of the input audio signal 110 is at $fs_{in}/2$=20 kHz. As a result of the upsampling operation 101, the upsampled audio signal 111 has an upsampled sampling rate of N x $fs_{in}$= 240 kHz, i.e. a Nyquist frequency of 120 kHz. The images of the sinusoids 201 at 2 / 3 kHz can be found at 40 kHz ± 2 / 3 kHz (reference numerals 202, 203), at 80 kHz ± 2 / 3 kHz (reference numerals 204, 205) and at 120 kHz - 2 / 3 kHz (reference numeral 206). As such, the upsampled audio signal 111 comprises frequency components which exceed the Nyquist frequency of 20 kHz of the input audio signal 110.

If it is assumed that the input audio signal 110 at input sampling rate $fs_{in}$=40 kHz is to be resampled to an output audio signal 113 at output sampling rate $fs_{out}$=48 kHz, the downsampler 103 has to perform a downsampling by a factor M=5. However, due to the fact that the upsampled audio signal 111 comprises frequency components which exceed the Nyquist frequency $fs_{out}/2$ = 24 kHz of the output audio signal 113 (see the sinusoid images 202, ..., 206), so called aliasing occurs, thereby creating undesirable contributions of the sinusoid images 202, ..., 206 to the spectrum of the output audio signal 113.

In order to avoid these undesirable contributions to the output audio signal 113, the upsampled audio signal 111 should be filtered using an anti-aliasing filter 102. The filter 102 should ensure that the spectral images 202,...,206 created during the upsampling operation 101 do not cause aliasing during the downsampling operation 103. This can be ensured by using a low pass filter having a cut-off frequency or a pass band edge / stop band edge which corresponds to the lower one of $fs_{out}/2$ and $fs_{in}/2$, i.e. which corresponds to the lower one of the Nyquist frequency of the input audio signal 110 and the output audio signal 113.

The anti-aliasing filters 102 are usually specified by one or more filter design parameters. Typically, the most important design parameters for this type of filters are "stop band rejection", "pass band edge", and "pass band ripple" (in particular with regards to the signal processing involved). These three design parameters may have an influence on the number of filter coefficients (i.e. the length) of the anti-aliasing filter 102, and therefore on the complexity of the rational resampler 100. Consequently, a trade-off between the imposed filter design parameters and the length of the anti-aliasing filter 102 must be found. By way of example, the pass band ripple may be set at 0.1dB and the available cycle budget (i.e. the available number of filter coefficients) may allow for a stop band rejection of around -50 dB.

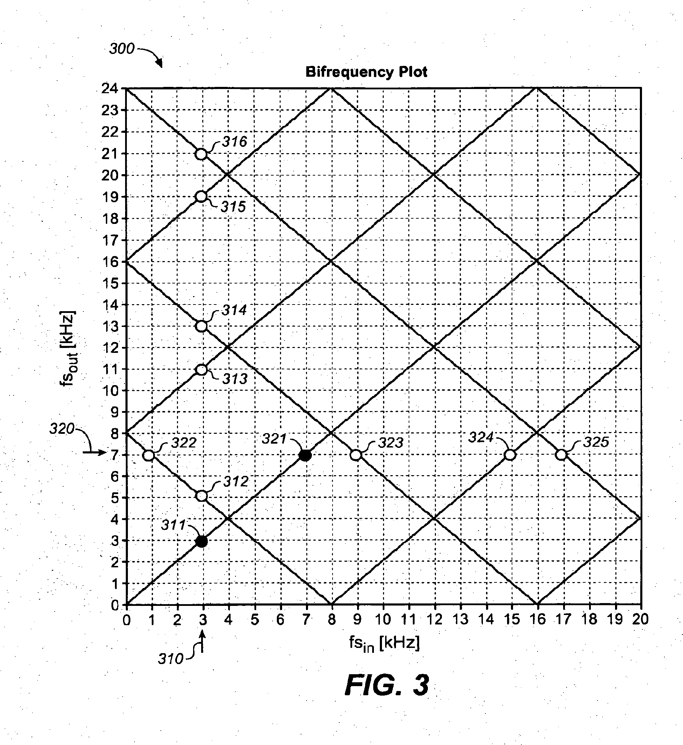

In the following, different aspects are described which should be taken into account when designing an appropriate anti-aliasing filter 102. For this purpose, reference is made to Fig. 3 where an example bifrequency map 300 for a rational resampler 100 is depicted. The resampler 100 is configured for an input signal 110 at an input sampling rate $fs_{in}$=40 kHz and an output signal 113 at an output sampling rate $fs_{out}$=48 kHz. The bifrequency map 300 is a means for illustrating the relationship between the frequency components of the input signal 110 (shown along the abscissa of the map 300) and the frequency components of the output signal 113 (shown along the ordinate of the map 300). As such, the bifrequency map 300 can be used to illustrate the complex transfer function of the rational resampler 100.

In column 310 of the bifrequency map 300 it can be seen that the frequency component at 3kHz of the input signal 110 creates an intended frequency component 311 at 3kHz in the output signal 113. However, due to imaging and aliasing effects, the frequency component at 3kHz of the input signal 110 also creates frequency components 312, 313, 314, 315, 316 at other frequencies of the output signal 113. These latter frequency components may be perceived as artifacts within the output signal 113.

In a similar manner, it can be seen in line 320 of the bifrequency map 300 that the frequency component at 7kHz of the output signal 113 receives an intended contribution from the frequency component 321 of the input signal 110. However, the frequency component at 7kHz of the output signal 113 also receives contributions 322, 323, 324, 325 from other frequencies of the input signal 110. These latter contributions may result in audible artifacts of the output signal 113.

As such, the bifrequeny map 300 may be used to illustrate how the different frequency components of the output signal 113 are influenced by the frequency components of the input signal 110. Consequently, the bifrequency map 300 may also be used to identify certain frequency ranges of the input signal 110 which do not influence the output signal 113. This knowledge on frequency ranges of the input signal 110 not influencing the output signal 113 may be taken into account during the design of the anti-aliasing filter 112. As a result, the performance of the filter 112 may be improved and/or the length / complexity of the filter 112 may be reduced.

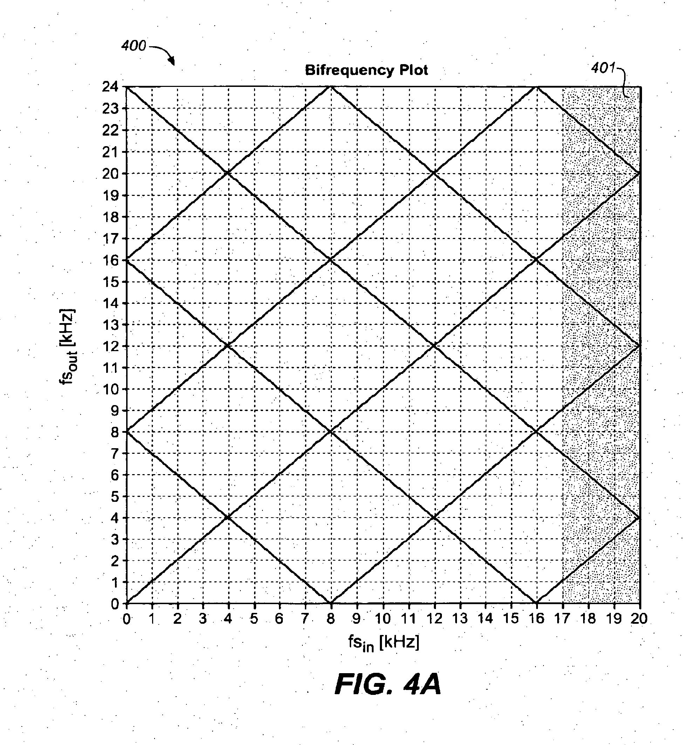

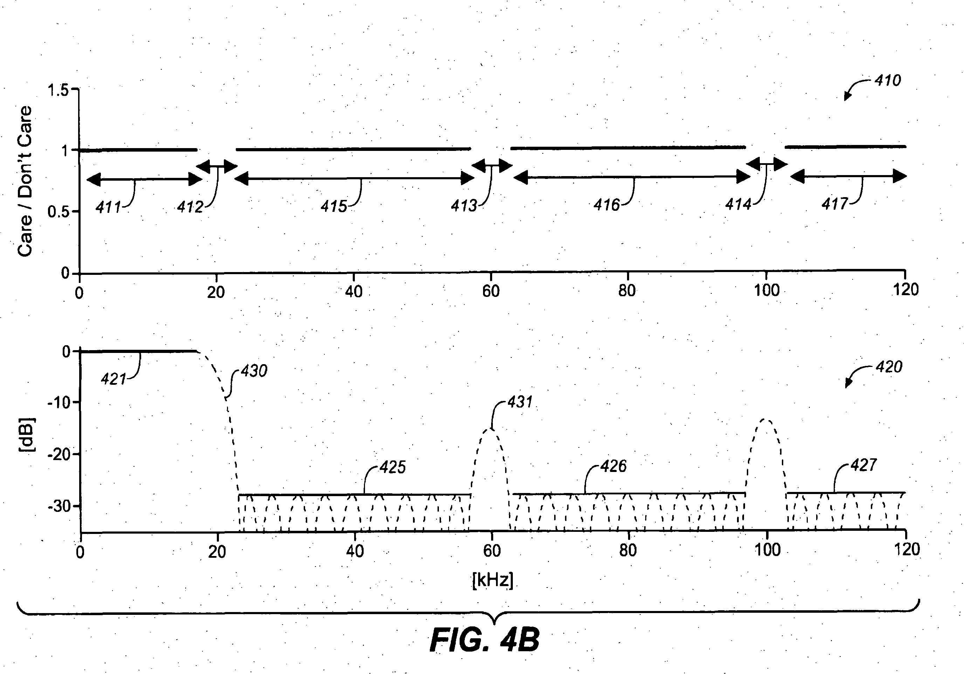

This is illustrated in Fig. 4a, where a certain frequency interval 401 of the input signal 110 is highlighted within a bifrequency map 400. It can be seen that if the input signal 110 does not comprise any signal components in the frequency range 401 of 17kHz to 20kHz, there is no contribution of these components of the input signal 110 to the frequency components of the output signal 113. This information can be used in the filter design as shown in Fig. 4b. In other words, if the input audio signal 110 has been band-limited to 17kHz or less, the filter 112 can be designed with additional degrees of freedom, due to the fact that no frequency components are to be expected in the frequency range of 17kHz to 20kHz of the input signal 110.

It can be seen in the graph 410 of Fig. 4b that the total frequency range of the upsampled signal 111 (i.e. the frequency range of 0kHz to 120kHz) can be partitioned into frequency ranges 412, 413, 414 where the frequency response of the filter 102 can take on any form (so called "don't care" intervals), as well as into frequency ranges 411, 415, 416, 417 where the frequency response of the filter 102 should take on a pre-determined form (so called "care" intervals). The "don't care" intervals 412, 413, 414 correspond to the frequency range of 17kHz to 20kHz (i.e. the frequency range within which the input signal 110 has no contributions), as well as to the images of this frequency range (i.e. 20kHz to 23kHz, 57kHz to 60kHz, 60kHz to 63kHz, 97kHz to 100kHz, 100kHz to 103kHz). As such, the information regarding the (missing) contributions of the input signal 110 can be used in order to provide additional degrees of freedom during the design of the filter 102.

The graph 420 illustrates the constraints or parameters imposed during the design of the filter 102. In the illustrated case, the order of the filter 102 (i.e. the number of filter coefficients) was set to 60. The stop band suppression or attenuation was set to -28dB within the "care" intervals 415, 416, 417 (constraints 425, 426, 427, respectively). The "care" interval 411 corresponds to the desired pass band 421 of the filter 102 (with no attenuation, i.e. a pass band attenuation of 0dB). No constraints or parameters were imposed for the "don't care" intervals 412, 413, 414.

As such, a set of constraints on the target frequency response of filter 102 can be formulated. These constraints apply to the "care" intervals 411, 415, 416, 417, whereas the target frequency response of the filter 102 can taken on any form within the "don't care" intervals 412, 413, 414. The filter coefficients of a filter 102 meeting or approximating these requirements may be determined using filter design methods such as the Parks-McClellan algorithm. This algorithm determines the set of filter coefficients that minimize the maximum deviation from the target frequency response.

The Parks-McClellan algorithm is directed at minimizing the maximum of an approximation error $E(f)$ given by

$$E(f) = W(f)\left|D(f) - H(f)\right|,$$

wherein $D(f)$ is the desired form of the low pass filter 102, i.e. the target frequency response, and is typically given by

$$D(f) = \begin{cases} 1, f \in [0, f_p] \\ 0, f \in [f_s, Mfs_{out}/2] \end{cases},$$

with $f_p$ being the pass band edge and $f_s$ being the stop band edge. As outlined above, other attenuation values may be defined in the pass band and/or the stop band. $W(f)$ is a frequency dependent weighting function of the approximation error. $H(f)$ is given by

$$H(f) = \sum_{k=0}^{n} d_k \cos(2k\pi f),$$

and relates to the frequency response of the filter 102 by $\exp(-j2\pi nf)H(f)$. The filter coefficients $h_k$ of filter 102 are given by

$$h_k = h_{2n-k}; d_{n-k} = 2h_k, k = 0,\ldots,n-1; d_0 = h_n.$$

The Parks-McClellan (Remez exchange) algorithm comprises the folloving steps:

1) Initialization: Choose an extremal set of frequencies $\{f^{(0)}\}$.
2) Finite Set Approximation (at iteration $m$): Calculate the best Chebyshev (i.e. minmax) approximation on the present extremal set, giving a derivation value $\delta^{(m)}$ for the minmax error on the present extremal set.
3) Interpolation: Calculate the error function $E(f)$ over the entire set of frequencies $\Omega$ using step (2).
4) Look for local maxima of $E^{(m)}(f)$ on the set of frequencies $\Omega$.
5) If $\max_{f\in\Omega} E^{(m)}(f) > \delta^{(m)}$, then update the extremal set to $\{f^{(m+1)}\}$ by picking new frequencies where $E^{(m)}(f)$ has its local maxima. Make sure that the error alternates on the ordered set of frequencies $\Omega$ as described in (4) and (5). Return to Step 2 and iterate.
6) If $\max_{f\in\Omega} E^{(m)}(f) \leq \delta^{(m)}$, then the algorithm is complete. Use the set $\{f^{(m)}\}$ and the interpolation formula to compute an inverse discrete Fourier transform to obtain the filter coefficients.

Details on the Parks-McClellan algorithm are outlined in T.Parks, J.McClellan, "Chebyshev Approximation for Nonrecursive Digital Filters with Linear Phase", IEEE Transactions on Circuit Theory, Vol. CT-19, No.2, March 1972, which is incorporated by reference.

The fact that certain frequency intervals of the target frequency response $D(f)$ are not specified, i.e. the fact that the target frequency response of the filter 102 comprises "don't care" intervals 412, 413, 414, typically leads to shorter filters 102 for achieving the target frequency response or to filters 102 of a given length achieving an improved approximation of the target frequency response of the filter 102 within the "care" intervals 411, 415, 416, 417. The "don't care" intervals 412, 413, 414 may be taken into account within the Parks-McClellan algorithm by ignoring the approximation error $E(f)$ within the "don't care" intervals 412, 413, 414. In other words, the approximation error $E(f)$ exceeding the derivation value $\delta$ within a "don't care" interval would not trigger a further iteration of the algorithm.

It should be noted that other filter design methods may be used to determined a filter 102 approximating the target frequency response.

The frequency response 430 of the resulting filter 102 is depicted in the graph 420 of Fig. 4b. It can be seen that the target frequency response $D(f)$ (reference numerals 421, 425, 426, 427) is well met within the "care" intervals 411, 415, 416, 417. On the other hand, it can be seen that within the "don't care" intervals 412, 413, 414 the frequency response 430 takes on arbitrary values and partially falls short of the stop band suppression 425, 426 imposed on neighboring "care" intervals 415, 416 (see reference numeral 431).

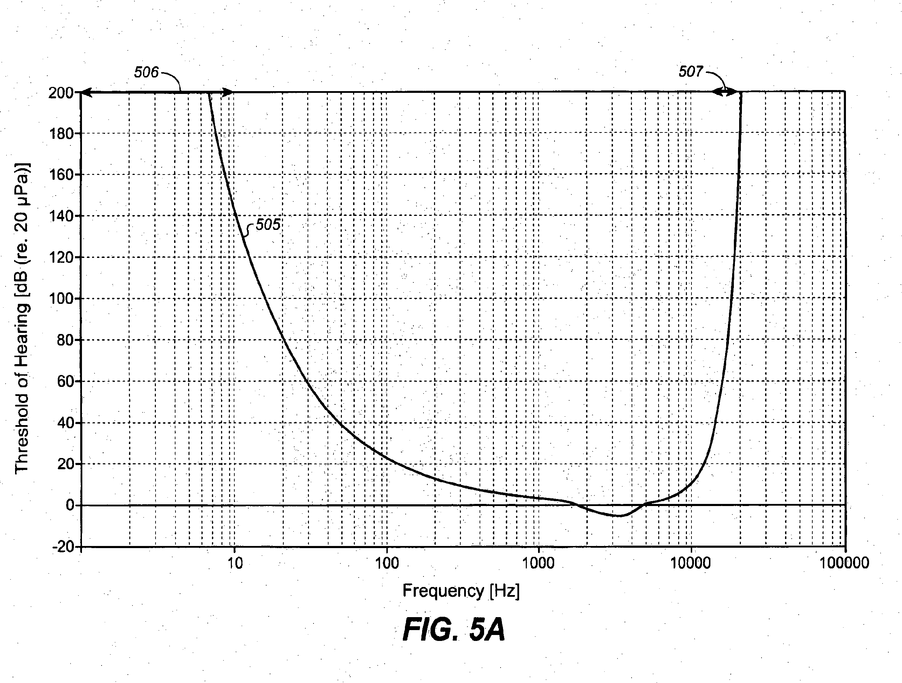

Alternatively or in addition, other aspects may be taken into consideration when designing the anti-aliasing filter 102. In particular, audio perceptual aspects, e.g. the absolute threshold of hearing (ATH), may be taken into consideration. Fig. 5a illustrates an example curve 505 of the ATH measured in dB SPL (Sound pressure level) across a frequency range of 0Hz to approximately 20kHz. It can be seen that in the lower frequency range 506 (approx. 10Hz and below) and in the higher frequency range 507 (approx 17kHz and higher) the ATH is very high indicating that a human is only able to perceive sounds in the frequency ranges 506, 507 at significant sound pressure levels.

The ATH curve 505 may be approximated by a mathematical equation, e.g. by the equation proposed by Terhardt:

$$\tau_{abs}(f) = 3.64\left(\frac{f}{1000}\right)^{-0.8} - 6.5\exp\left(-0.6\left(\frac{f}{1000} - 3.3\right)^2\right) + 10^{-3}\left(\frac{f}{1000}\right)^4,$$

wherein the frequency f is measured in Hz.

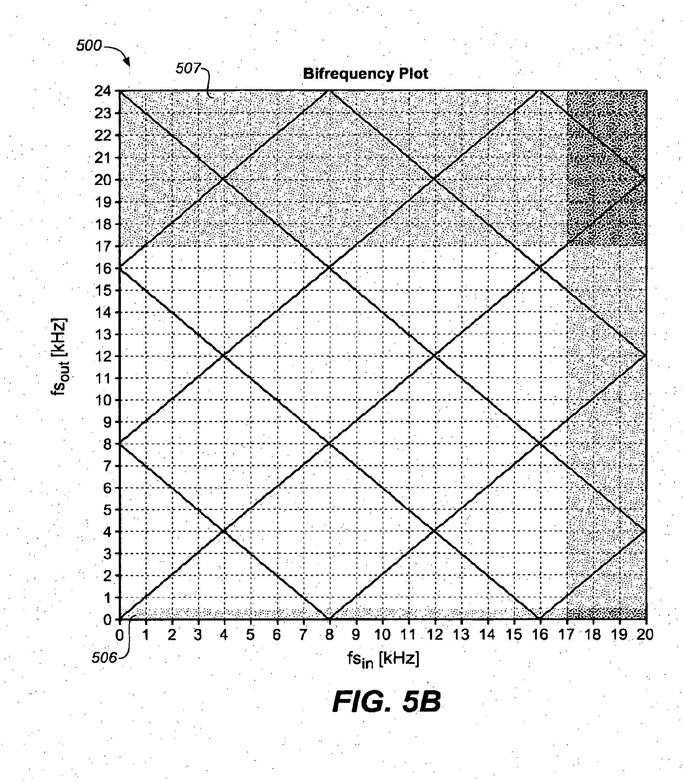

Fig. 5b illustrates the frequency intervals 506, 507 corresponding to high values of ATH in the bifrequency map 500. It can be seen that these frequency ranges 506, 507 of the output signal 113 may have high imaging / aliasing contributions from the input signal 110, without being audible to a listener of the output signal 113. In other words, due to the high absolute threshold of hearing in the frequency ranges 506, 507, imaging / aliasing artifacts within the output signal 113 are of reduced importance to the perceived quality of the output signal 113. It is proposed to use this knowledge during the design of the anti-imaging / anti-aliasing filter 102.

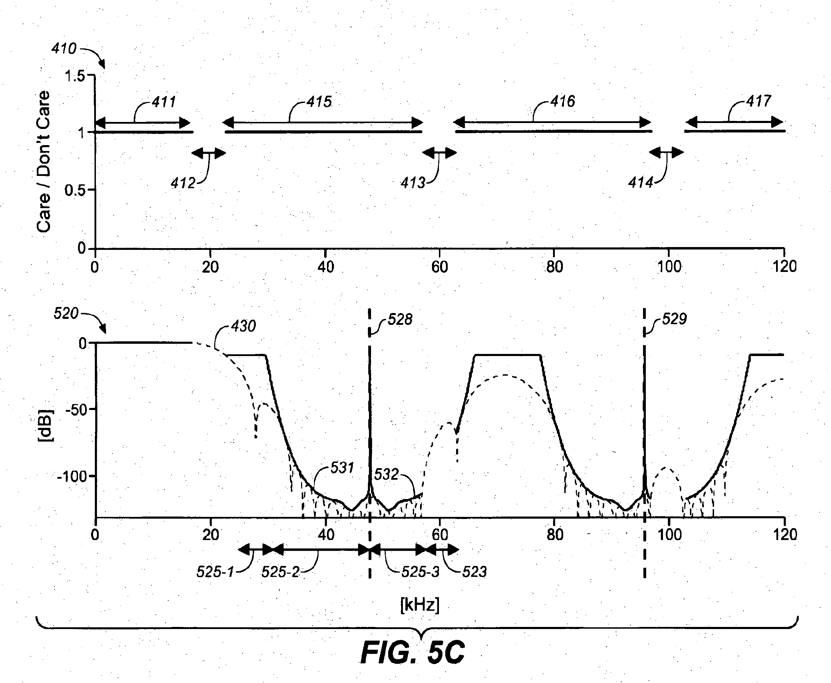

Fig. 5c shows how this information regarding the absolute threshold of hearing can be taken into account during the design of the anti-imaging / anti-aliasing filter 102. In a similar manner to Fig. 4b, the graph 410 shows the "don't care" intervals 412, 413, 414 which are due to missing frequency components of the input signal 110. Furthermore, the "care" interval 411 for the pass band and the "care" intervals 415, 416, 417 for the stop band are illustrated. It should be noted that the "don't care" intervals and the "care" intervals can take on various forms. In particular, if the input signal 110 covers the complete Nyquist range (up to 20Hz), there may be no "don't care" intervals 412, 413, 414.

The graph 520 of Fig. 5c illustrates the allowed deviation from the target frequency response of the filter 102. The target frequency response $D(f)$ defined by a certain pass band attenuation (e.g. 0dB) and a certain stop band attenuation (e.g. -100 dB). The allowed deviation indicates how much the frequency response of the filter 102 may deviate from the target frequency response. The allowed deviation may be used as an alleviated constraint during the design of the filter 102. In particular, the allowed deviation may be taken into account within the weight function $W(f)$ of the above mentioned approximation error $E(f)$. Even more particularly, the weight function $W(f)$ may be proportional to the inverse of the allowed deviation.

I.e. the graph 520 illustrates the constraints which are used during the design of the filter 102. In a similar manner to Fig. 4b, no constraints are imposed on the frequency response of the filter 102 within the "don't care" intervals 412, 413, 414. In order to take into account the frequency evolution of the absolute threshold of hearing, the allowed deviation from the target frequency response within the example "care" interval 415 is associated with the ATH curve 505. As such, the segments 525-1, 525-2, 525-3 of the allowed deviation from the target frequency response of filter 102 within the "care" interval 415 are derived from the ATH curve 505.

It should be noted that frequency ranges for which the ATH value exceeds a certain level, i.e. frequency ranges which cannot reasonably comprise audible frequency components of the output signal 113, may be declared as "don't care" intervals, thereby removing further constraints during the design of filter 102 in this particular frequency range. This is illustrated in segment 525-1 (associated with a frequency range of approx 20-24kHz), where the ATH value is very high. Consequently, the number of degrees of freedom on the frequency response of filter 102 can be increased.

As illustrated in Fig. 5b, the absolute threshold of hearing affects the way that frequencies of the output signal 113 are perceived by a listener. Consequently, the ATH curve 505 should be reflected in the relevant frequency diagram of the output signal 113. This is illustrated in graph 520 of Fig. 5c, where the dotted lines 528, 529 reflect the frequencies corresponding to 2 x and 4 x the Nyquist frequency of 24kHz of the output signal 113. These dotted lines 528, 529 are mirroring lines of the images of the upsampled signals 111 or 112 prior to the down-sampling of the down-by-M decimator 103 (similar to the mirroring lines at 40kHz and 80 kHz depicted in Fig. 2).

In view of the above, the ATH curve 505 is fitted into the frequency diagram of the upsampled output signal while taking into account the images created due to the (imaginary) up-by-M upsampling (i.e. prior to the down-by-M decimation). As such, the allowed deviation from the target frequency response of the filter 102 in the "care" frequency interval 415, 416, 417 is derived from images of the ATH curve 505 in the frequency diagram of the upsampled output signal, i.e. in the frequency diagram mirrored in accordance to the Nyquist frequency of the output signal 113. This is shown in Fig. 5c where the segment 525-2 of the allowed deviation from the target frequency response 531 corresponds to a scaled and mirrored version of the ATH curve 505 ranging from frequencies 0kHz to approx. 20kHz. The segment 525-3 of the allowed deviation from the target frequency response 532 corresponds to a scaled version of the ATH curve 505 at the frequencies 0kHz to 17kHz.

Segment 525-3 is adjacent to segment 523 corresponding to the "don't care" interval 513. The fact that the target frequency response 532 is left blank within the segment 523 indicates that no constraints are imposed on the target frequency response 532 within the "don't care" interval 513.

Overall, allowed deviations from the target frequency response 531, 532 in the stop band are obtained which is made up of a succession of scaled and possibly mirrored images of the ATH curve 505. These allowed deviations from the target frequency response 531, 532 may be interrupted by "don't care" frequency intervals. Using the allowed deviation from the target frequency response 531, 532 as an input to filter design methods such as the Parks-McClellan algorithm provide the coefficients of an anti-aliasing filter 102. The resulting frequency response 430 of filter 102 is shown in graph 520 of Fig. 5c. It can be seen that the stop band rejection in the proximity of the mirroring lines 528, 529 is very high, thereby significantly attenuating the images and aliases in the frequency ranges which are well perceived by a human being. At the same time, the stop band rejection is relatively weak for frequency ranges which are not well perceived by a human being.

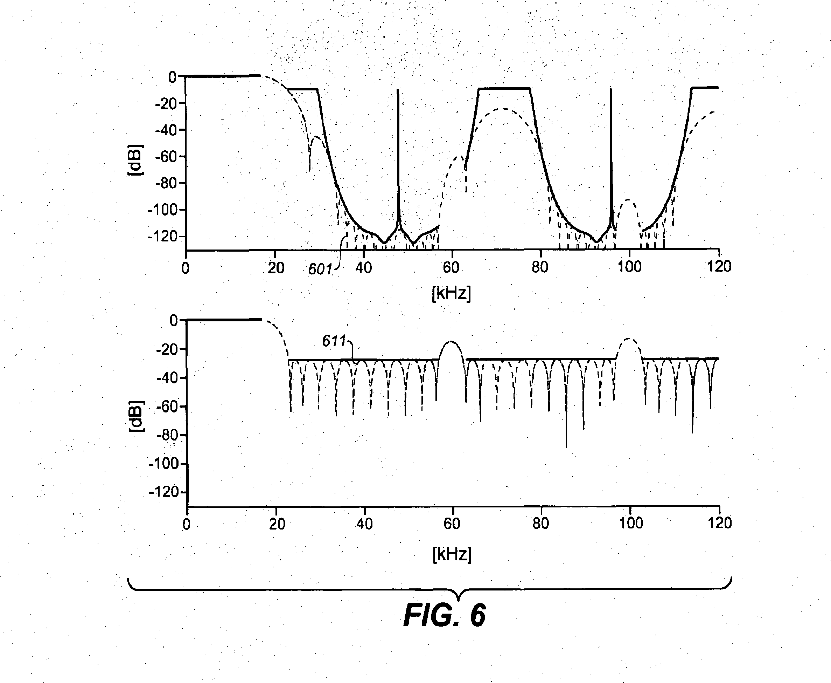

In Fig. 6 a comparison between the anti-aliasing filter 601 designed using a allowed deviation derived from the ATH curve 505 and a conventional anti-aliasing filter 611 is shown. Both filters 601, 611 have the same number of filter coefficients (60 coefficients). It can be seen that filter 601 exhibits a significantly higher stop band rejection than filter 611 in frequency ranges associated with low ATH values (i.e. in frequency ranges associated with a relatively high auditory sensitivity). As a result, the perceived quality of the resampled output signal is improved when using filter 601.

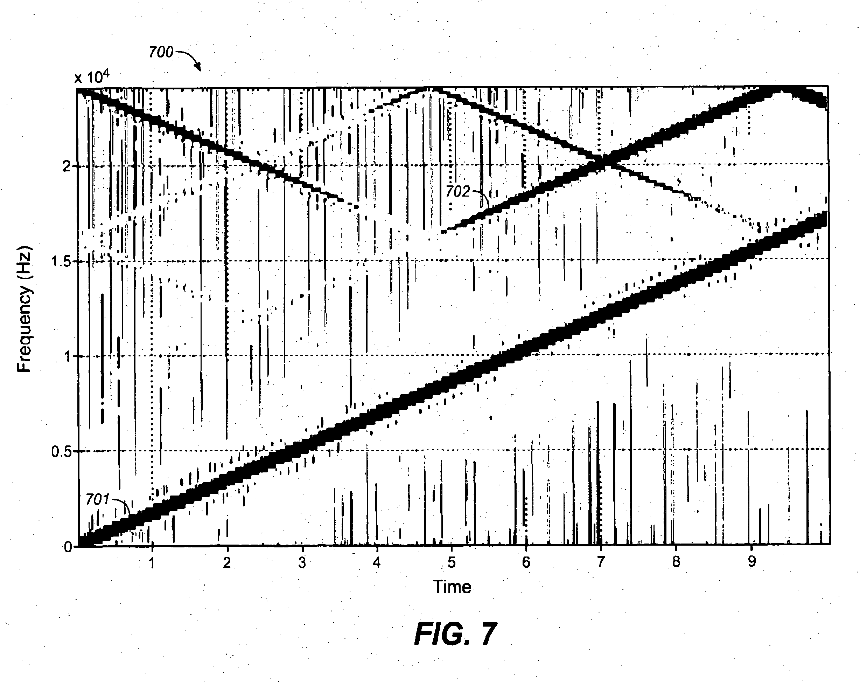

The effect of the psychoacoustic resampler 100 using an anti-aliasing filter 601 can be seen in Fig. 7, where the frequency diagram 700 of a resampled output signal 113 is depicted. The abscissa indicates the time. The input signal 110 corresponds to a sinusoid which changes from a frequency of 0kHz (at the time of 0 seconds) to 17kHz (at the time of 10 seconds). As such, the abscissa actually indicates the frequency of the input signal 110. The ordinate indicates the frequency spectrum of the resampled output signal 113 at a particular time instant. It can be seen that the frequency spectrum of the output signal 113 mainly comprises the sinusoid 701 of the input signal 110. In addition, the output signal 113 comprises frequency components 702 at higher frequencies above 15kHz. These frequency components 702 are due to imaging / aliasing of the resampler 100. However, due to the psychoacoustic design of the anti-aliasing filter 102 having the frequency response 601 these frequency components 702 are not perceived by a human listener.

In the following further aspects are outlined which may be taken into consideration when designing the anti-aliasing filter 102. For this purpose, the imaging and aliasing caused by rational resampling is analyzed in further detail from a mathematical perspective.

As outlined above, $fs_{in}$ and $fs_{out}$ are the input and output sampling rates, respectively. It has been outlined in the context of Fig. 1 that the resampling by rational ratios $M/N = fs_{in}/fs_{out}$ (with M, N being mutually prime), can be implemented by an upsampling by $N$ step 101, followed by a filter 102, followed by a downsampling by $M$ step 103. In the course of upsampling, $N$ - 1 images of the original signal are created, at multiples of the original sampling rate $fs_{in}$. That is, a component at baseband frequency $f_{bb} \in [fs_{in}/2;fs_{in}/2]$ will be imaged to components at frequencies $f_{bb} + n \cdot fs_{in}$ ($n$ = 1...$N$ - 1). If one were to downsample by the same ratio $M = N$, all these images would alias back into the original component, i.e. upsampling and downsampling (by the same factor $M = N$) are inverse processes.

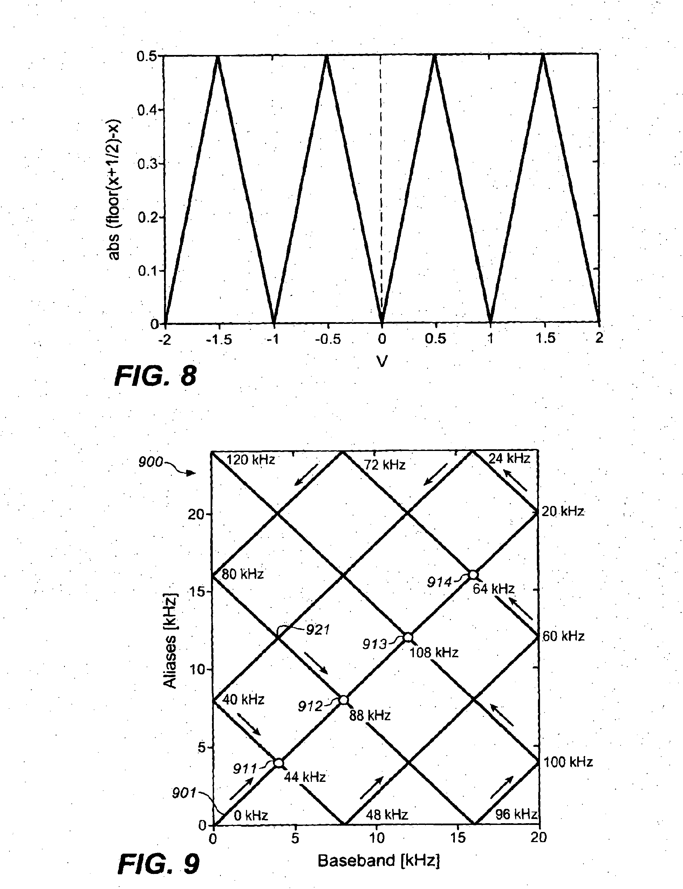

A triangle wave function $T(x) = |frac(x + ½) - ½|$ may be defined, where the function "frac(.)" denotes the fractional part of its argument. Such a triangle wave function is illustrated in Fig. 8. The triangle wave function T(x) can be used to illustrate the imaging and aliasing operations of the upsampling and the downsampling, respectively. In particular, the triangle wave function $T(x)$ can be used to illustrate that frequencies in the baseband $f_{bb} \in [-fs_{in}/2;fs_{in}/2]$, which correspond to the abscissa interval $x_{bb} \in [-0.5;0.5]$ of the triangle wave function $T(x)$ are imaged to frequencies $f_{bb} + n \cdot fs_{in}$, which correspond to $x_{bb} + n$ of the triangle wave function $T(x)$.

On the other hand, looking at an image frequency $f = f_{bb} + n \cdot fs_{in}$, the triangle wave function $T(x)$ can be used to derive the baseband frequency $f_{bb}$; that the image frequency $f$ originated from

$$f_{bb} = fs_{in} \cdot T\left( f / fs_{in} \right). \qquad (1)$$

Likewise, during downsampling to the output sampling rate $fs_{out}$, the image frequency $f$ aliases back into the baseband via the function $f_{al} = fs_{out} \cdot T(f/fs_{out})$, wherein $f_{al}$ is the alias component (in the baseband of the output signal 113) originating from image frequency $f$ Vary ing the parameter $f$ and plotting the periodically varying baseband component $f_{bb}$ against the alias component $f_{al}$ produces the Lissajous-like Fig. 9 (also referred to herein as the bifrequency plot).

The bifrequency plot 900 of Fig. 9 is illustrated for the example of $fs_{in} = 40Hz$ and $fs_{out} = 48Hz$, i.e. for a rational resampler with $N = 6$ and $M = 5$. The bifrequency plot 900 shows several aspects of the resampling process. First, it shows that for every input frequency (plotted along the abscissa), there are $N - 1 = 6 - 1 = 5$ images. The images of each input frequency can be seen when following the diagonal line 901 starting at the point (0kHz,0kHz) up to the point (20kHz,20kHz), then turning left and following the line 901 along the arrow to point (16kHz,24kHz), then turning left along the arrow to point (0kHz,8kHz), and so on, to the point (0kHz,24kHz). The line 901 represents the frequency axis of the upsampled signal 111 and goes from 0kHz at the beginning to 120kHz at the end. As such, line 901 corresponds to the frequency axis of Fig. 2 folded into the bifrequency plot 900. As shown in Fig. 3, the upsampling by N creates 5 images (e.g. images 312, 313, 314, 315, 316) from an input frequency 310, i.e. an input frequency 310 appears N times in the upsampled signal 111. In particular, images of an input frequency $f_{bb}$ appear at the frequencies $f_{bb} + n \cdot fs_{in}$, for $n = 1,..., N/2 - 1$ and $- f_{bb} + n \cdot fs_{in}$ for $n = 1,...,N/2$.

The bifrequency plot 900 also shows that every frequency in the output domain can be an alias of M=5 frequencies in the input domain, one being the same frequency in the input signal itself. This had already been shown in Fig. 3, where frequency 321 in the output domain receives aliasing contributions from input frequencies 322, 323, 3224, 325 plus input frequency 321 (corresponding to the output frequency 321).

Furthermore, points 911, 912, 913, 914 can be identified in the bifrequency map 900, where the alias component of an image of the input frequency coincides with the input frequency. These points 911, 912, 913, 914 may be referred to as self-masking points. By way of example, point 911 is positioned at coordinates (4kHz,4kHz) in the bifrequency diagram 900. Line 901 (corresponding to the frequency axis of the upsampled signal 111) traverses point 911 twice, a first time at 4kHz and a second time at 44kHz. This means that not only the original input frequency $f_{bb} = 4kHz$, but also its image $f_{bb} + fs_{in} = 44kHz$ contributes to the output frequency $f = 4kHz$. In a similar manner, at point 912, not only the original input frequency $f_{bb} = 8kHz$, but also its image $f_{bb} + 2fs_{in} = 88kHz$ contributes to the output frequency $f = 8kHz$. In view of the fact that the input audio signals are real signals, their frequency spectrum is symmetrical. Consequently, not only the original input frequency $f_{bb} = 16kHz$, but also its image $- f_{bb} + 2fs_{in} = 64kkHz$ contributes to the output frequency $f = 16kHz$ (point 914), as well as, not only the original input frequency $f_{bb} = 12kHz$, but also its image $- f_{bb} + 3fs_{in} = 108kkHz$ contributes to the output frequency $f = 12kHz$ (point 913).

In addition, one can identify points where two aliases which are due to images of the same input frequency coincide with one another (while not coinciding with the original input frequency). These frequencies may require particular attenuation by the filter 102 because the two aliasing components might constructively interfere. These points may be referred to as self interference points. By way of example, point 921 at frequency coordinates (4kHz,12kHz) is traversed twice by the frequency axis 901 of the upsampled signal 111, once at 36kHz (i.e. at- $f_{bb} + fs_{in}$, with $f_{bb} = 4kHz$) and a second time at 84kHz (i.e. $f_{bb} + 2fs_{in}$ with $f_{bb} = 4kHz$). As can be seen, the two images of the baseband frequency at 4kHz contribute to the output frequency at 12kHz, i.e. the images of the baseband frequency $f_{bb}$ contribute to an output frequency $f_{al}$ which is different from $f_{bb}$.

In order to further analyze the generation of images during the upsampling operation 101, it is assumed in the following that M=1. As such, the relation between the input sampling rate $fs_{in}$ and the output sampling rate is $fs_{out} = N \cdot fs_{in}$. Let $\tau_{abs}(f)$ be the absolute threshold of hearing (ATH) at frequency $f$, such that a tone with a signal level lower than $\tau_{abs}(f)$ will not be audible. A mathematical approximation of the ATH curve 505 has been provided in the context of Fig. 5a.

Considering the images at frequencies $f = n\, fs_{in}/2$, $n = 1...N$, it is the purpose of the anti-imaging (upsampling) filter 102 to reduce the images to a level that will not be audible. To determine whether an image with energy level $L$ at frequency $f$ will be audible, the signal level $L$ at frequency $f$ can be compared to the ATH curve $\tau_{abs}(f)$. If $L < \tau_{abs}(f)$, the image will not be audible.

At the time of designing the filter 102, the signal level of the baseband audio signal 110 it typically not known, and thus the signal level $L$ of the images is not known. The higher the signal level of the input signal 101, the more attenuation is required by filter 102. However, the assumption can be made that the signal level of the baseband audio signal is below the threshold of pain $\tau_P(f_{bb})$ (where $f_{bb}$ is given by equation 1). By way of example, the threshold of pain $\tau_P(f_{bb})$ can be approximated by a frequency independent constant of 120dB SPL. In view of the above assumptions, the attenuation of the filter should be equal to or better than $\tau_{abs}(f)/\tau_P(f_b)$, i.e. the magnitude of the frequency response of the filter 102 should be

$$|H(f)|^2 < \tau_{abs}(f)/\tau_P(f_{bb}). \qquad (2)$$

A possible way of designing such a filter 102 may be the above described Parks-McClellan algorithm, with pass band gain of 1 and a stop band gain of 0, i.e. with a target frequency response

$$D(f) = \begin{cases} 1, f \in [0, f_p] \\ 0, f \in [f_s, Mfs_{out}/2] \end{cases},$$

as outlined above. The linear error weighting function $W(f)$ within the stop band may be set to

$$W(f) = \sqrt{\tau_P(f_{bb})/\tau_{abs}(f)}.$$

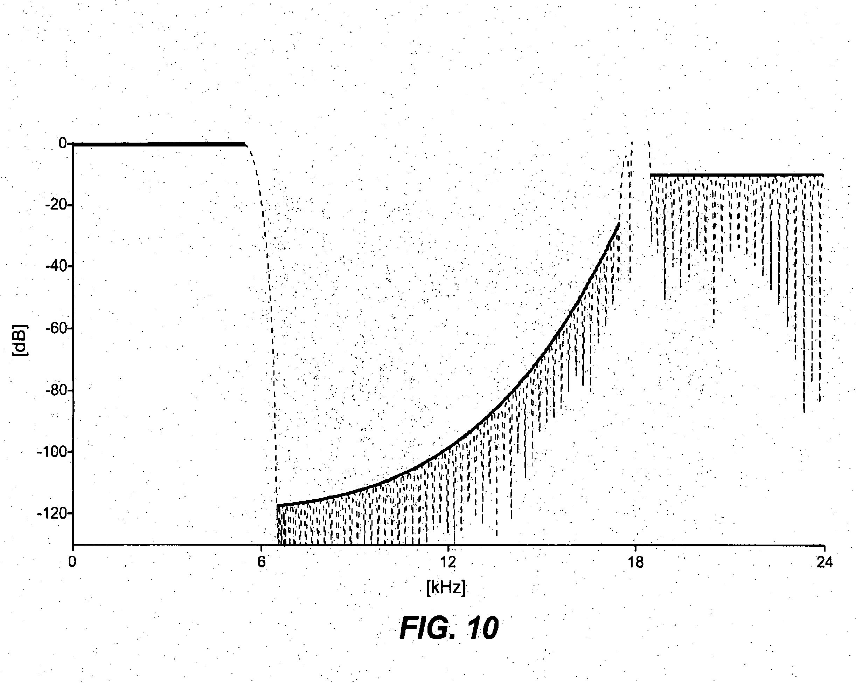

Fig. 10 shows the frequency response of a psychoacoustic filter 102 obtained in accordance with the above mentioned method. The filter is used for removing the images of input signals 110 with an input sampling rate $fs_{in}$ = 12*kHz* and an upsampling factor N=4. The pass band weighting has been set such that the pass band ripple stays below 0.1 dB. Furthermore, the error weighting function has been modified such that in the frequency interval above approx. 18 kHz, no unconstrained amplification occurs due to the high values of the ATH curve 505 (possibly except for the "don't care" region, where no energy can be aliased). In addition, it has been assumed that the audio signal is already band limited to below 5.5 kHz (i.e. at 90% of the Nyquist rate), thereby providing "don't care" intervals.

Likewise, when downsampling an input signal by a factor M (i.e. N=1) from an input sampling rate $fs_{in}$ to an output sampling rate $fs_{out} = fs_{in}/M$, the threshold of hearing curve 505 may be used to derive the allowed deviations from the ideal stop band suppression. However, for audio applications, the audio input signal 110 is already in the audible frequency range. Consequently, also the downsampled output signal 113 is in the audible frequency range. Therefore, the potential of using the high thresholds of hearings for high frequencies in a pure downsampling scenario is limited.

As has been outlined in the context of Fig. 9, certain input frequencies $f_{bb}$ create images $f_{bb} + nfs_{in}$ and/or $-f_{bb} + nfs_{in}$ during the upsampling operation 101 which are aliased back to the same output frequencies $f_{al}$, with $f_{al} = f_{bb}$, during the downsampling operation 103. As such, the alias component of the output signal is directly dependent on the input signal components at the same frequency. This observation may be used to exploit perceptual self-masking effects during the filter design.

Let $\mu(f,f_0)$ be the relative masking threshold afforded by a single tone with signal level $L$ at frequency $f_0$. That is, a tone with level $L'$ at frequency $f$ where $L' < L \cdot \mu(f, f_0)$ will not be audible. An approximation of the relative masking threshold curve (also referred to as tone masking tone, TMT) may be given by

$$\mu(f, f_0) = \begin{cases} -27 + 25(Bark(f) - Bark(f_0))[dB], f < f_0 \\ -27 - 10(Bark(f) - Bark(f_0))[dB], f \geq f_0 \end{cases},$$

wherein the Bark scale can be approximated by

$$Bark(f) = 13 \cdot \text{atan}(0{,}76 \cdot 10^{-3} f) + 3{,}5 \cdot \text{atan}(0{,}13 \cdot 10^{-3} \text{f})^2.$$

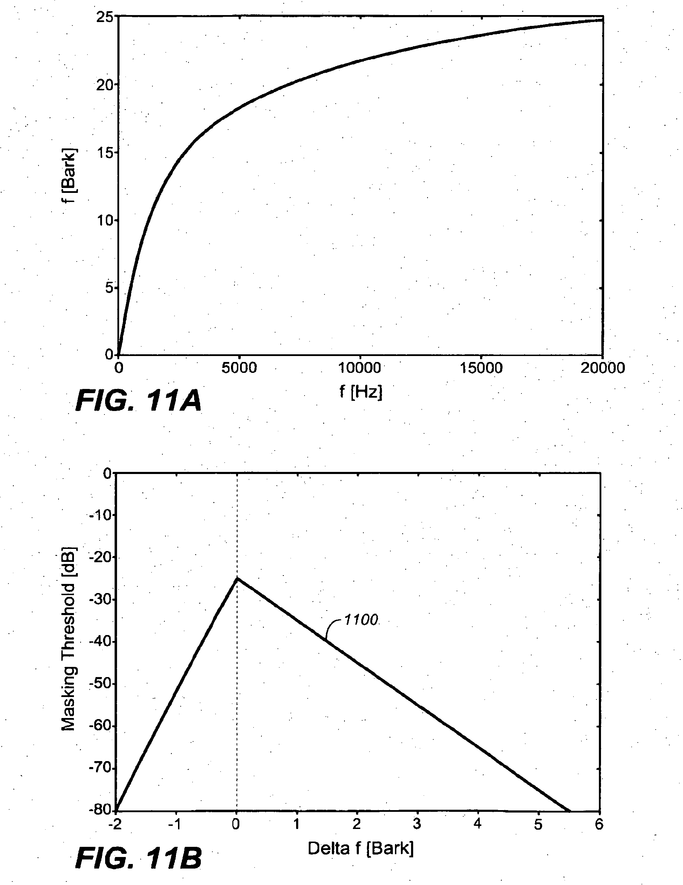

The Bark scale is illustrated in Fig. 11a and the relative masking threshold curve 1100 for relative frequency deviations from the masker frequency $f_0$ is illustrated in Fig. 11b. It can be seen that a frequency $f$ which is close to the masker frequency $f_0$ is only audible, if its signal level exceeds the signal level $L$ at frequency $f_0$ minus 27dB.

In the following, a signal component of the upsampled signal 110 at frequency $f \in [0; N \cdot fs_{in}/2]$ in the intermediate, i.e. upsampled, frequency domain is considered. This component at frequency $f$ is an image of the baseband signal component at $f_{bb} = fs_{in} \cdot T(f/fs_{in})$. During the downsampling process, it will be aliased to a component at frequency $f_{al} = fs_{out} \cdot T(f/fs_{out})$ of the output signal 113.

Let $L_{al} = L \cdot |H(f)|^2$ be the signal level of the alias component at frequency $f_{al}$. The alias component at $f_{al}$ may be subject to masking from the component at $f_{bb}$ that it originated from via the upsampling-filtering-downsampling process. This may be the case, if the alias component at $f_{al}$ originated from an input signal component at $f_{bb}$, wherein $f_{bb} \approx f_{al}$. In

order to exploit the masking from the component at $f_{bb}$ i.e. in order to ensure that the alias component at $f_{al}$ is not audible the signal level of the alias component should be $L_{al} = L \cdot |H|^2 \leq L \cdot \mu(f_{al}, f_{bb})$, i.e.

$$|H|^2 \leq \mu(f_{al}, f_{bb}). \qquad (3)$$

As can be seen in Fig. 11b, the relative masking threshold curve $\mu(f_{al}, f_{bb})$ will reach its maximum of -27 dB at the points of self masking, i.e. at points where an alias component at $f_{al}$ is masked by a frequency component which originates from a baseband component at $f_{bb}$, with $f_{al} = f_{bb}$.

As outlined in the context of Fig. 9, self-masking occurs in the vicinity of the frequencies of the self masking points 911, 912, 913, 914. As has been outlined above, the self masking points 911, 912, 913, 914 have the characteristic that an image of the spectrum of the input signal at a given frequency aliases to the spectrum of the output signal at the same given frequency. As such, the aliased image is subjected to the masking of the original spectrum of the input signal at the given frequency. This finding can be used for defining allowed deviations of the frequency response of the anti-aliasing filter 102 during the filter design. In particular, the attenuation performed by the filter 102 on the respective images of the original spectrum can be reduced due to the self-masking effect.

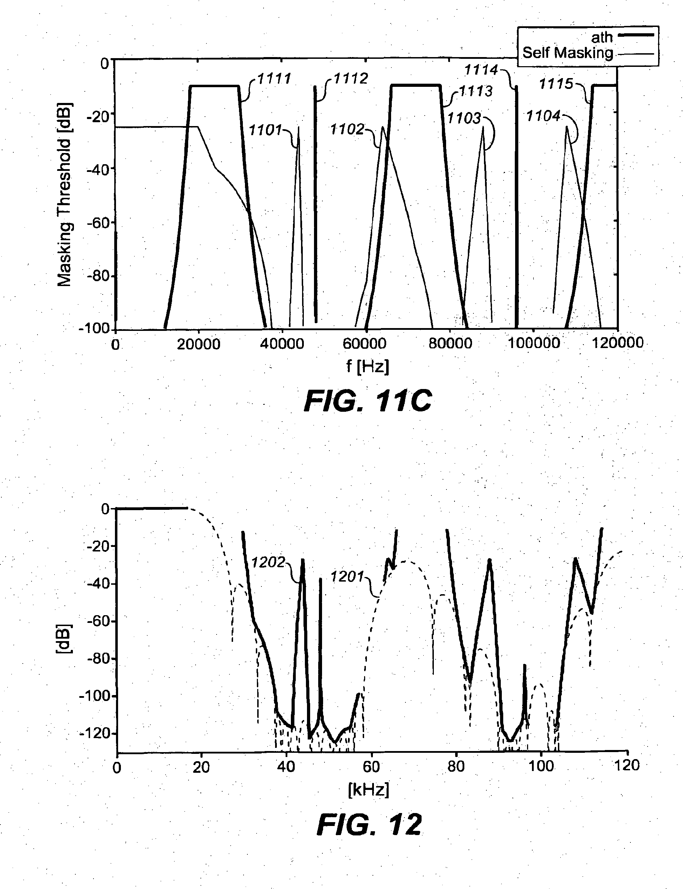

This is illustrated in Fig. 11c, where the allowed deviations for an example filter 102 in a 40kHz to 48kHz resampler are illustrated. Fig. 11c illustrates the allowed deviations 1101, 1102, 1103, 1104 which are due to the self-masking effect. It can be seen that the allowed deviations 1101, 1102, 1103, 1104 are positioned around the frequencies 44kHz, 64kHz, 88kHz, 108kHz, respectively. These frequencies in the intermediate domain correspond to the frequencies associated with the self-masking points 911, 914, 912, 913, respectively. These frequencies may be referred to as the maskee frequencies (in the intermediate frequency domain). The frequency which a maskee frequency aliases to, may be referred to as the corresponding baseband masker frequency. The form of the allowed deviations 1101, 1102, 1103, 1104 corresponds to the relative self-masking threshold curve illustrated in Fig. 11b, however, illustrated on a linear scale instead of a Bark scale.

Furthermore, Fig. 11c illustrates the allowed deviations 1111, 1112, 1113, 1114, 1115 which are due to the ATH curve 505. As such, various perceptual contributions to the allowed deviations of a frequency response from the target frequency response have been identified. The allowed deviations due to the ATH curve 505 may be described using equation (2), whereas the allowed deviations due to the self-masking threshold curve 1100 may be described using equation (3). Making the assumption that the alias will be inaudible if its signal level is below either the absolute threshold of hearing or the masking threshold, provides the following constraint on the magnitude of the transfer function (i.e. the allowed deviations from the target frequency response)

$$|H(f)|^2 \leq \max\left(\tau_{abs}(f_{al}) / \tau_P(f_{BB}), \mu(f_{al}, f_{BB})\right).$$

The stop band gain may be restricted to unity or lower in order to avoid amplification of aliases. Fig. 12 illustrates the resulting filter frequency response 1201 using the above mentioned function of allowed deviations 1202. The illustrated filter 102 requires 10 taps per phase (i.e. 60 coefficients overall). It can be seen that the frequency response 1201 follows well the allowed deviations 1202 provided by the perceptual frequency response associated with the ATH curve 505 and the self-masking threshold curve 1100.

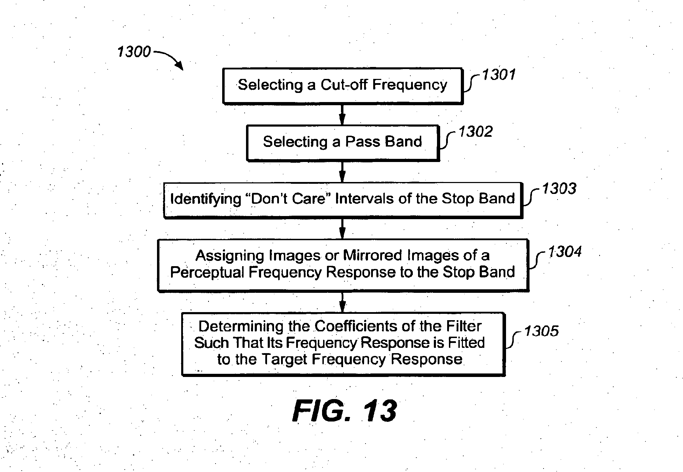

In Fig. 13 an example method 1300 for designing a psychoacoustic filter for the resampling of audio signals is illustrated. The method 1300 comprises a plurality of steps 1301 to 1304 related to the specification of a target frequency response. In step 1301 a cut-off frequency (and/or a pass band edge / stop band edge) of the target frequency response is selected. As outlined in the present document, the cut-off frequency may be selected as the smaller one of the Nyquist rate of the input audio signal and the Nyquist rate of the output audio signal. Furthermore, in step 1302 a pass band of the target frequency response is selected. The selection of the pass band comprises the selection of the frequency range of the pass band, as well as the selection of a target attenuation of the target frequency response within the pass band.

In step 1303 "don't care" intervals of the stop band are identified. The "don't care" intervals may be due to frequency intervals of the input audio signal having low energy, i.e. having an energy value below an energy threshold. Furthermore, the "don't care" intervals may be due to spectral images and/or mirrored images of such low energy frequency ranges of the input audio signal. Alternatively or in addition, the "don't care" intervals may be due to frequency ranges associated with a low auditory spectral sensitivity of a human listener. As outlined in the present document, images and/or mirrored images of such frequency ranges may be selected as "don't care" intervals of the stop band.

In step 1304 images or mirrored images of a perceptual frequency response indicative of the auditory spectral sensitivity of a human listener are assigned to the stop band, in particular to the frequency ranges of the stop band outside of the "don't care" intervals. The perceptual frequency response may be associated with a scaled and/or shifted version of the absolute threshold of hearing curve, thereby attributing different degrees of attenuation to different frequencies of the stop band. Alternatively or in addition, the perceptual frequency response may be associated with the self-masking threshold curve at particular frequencies.

As a result of steps 1301 to 1304 a target frequency response and allowed deviations from this target frequency response of the psychoacoustic filter 102 have been determined. Within the "don't care" intervals, the allowed deviation from the target frequency response takes on arbitrary or undefined values. Outside the "don't care" intervals of the stop band, the allowed deviation from the target frequency response is associated with a perceptual frequency response indicative of the auditory spectral sensitivity of a human listener. In step 1305 the coefficients of the filter are determined using filter design methods such as a Parks-McClellan algorithm. Such filter design methods determine the filter coefficients such that the frequency response of the resulting filter is fitted to the target frequency response, while taking into account the allowed deviation from the target frequency response.

In the present document, a method and system for designing psychoacoustic anti-aliasing filters has been described. The resulting filters may be used to implement psychoacoustic resamplers 100 which perform rational resampling at reduced computational complexity and/or at improved perceptional quality.

The methods and systems described in the present document may be implemented as software, firmware and/or hardware. Certain components may e.g. be implemented as software running on a digital signal processor or microprocessor. Other components may e.g. be implemented as hardware and or as application specific integrated circuits. The signals encountered in the described methods and systems may be stored on media such as random access memory or optical storage media. They may be transferred via networks, such as radio networks, satellite networks, wireless networks or wireline networks, e.g. the internet. Typical devices making use of the methods and systems described in the present document are portable electronic devices or other consumer equipment which are used to store and/or render audio signals. The methods and system may also be used on computer systems, e.g. internet web servers, which store and provide audio signals, e.g. music signals, for download.

## Claims

**1.** A method for designing a filter (102) configured to reduce imaging and/or aliasing of an output audio signal (113) at an output sampling rate ($fs_{out}$); wherein the output audio signal (113) is a resampled version of an input audio signal (110) at an input sampling rate ($fs_{in}$);
wherein the ratio of the output sampling rate ($fs_{out}$) and the input sampling rate ($fs_{in}$) is a rational number N/M;
wherein the filter (102) operates at an upsampled sampling rate which equals N times the input sampling rate ($fs_{in}$);
the method comprising

- selecting an allowed deviation of the frequency response (531, 532) of the filter (102) within a stop band of the filter (102) based on a perceptual frequency response indicative of an auditory spectral sensitivity; wherein the allowed deviation indicates a deviation of the frequency response (531, 532) of the filter (102) from a predetermined attenuation within the stop band;
- the step of selecting the allowed deviation of the frequency response (531, 532) of the filter (102) within the stop band comprising the step of partitioning the stop band into a plurality of frequency intervals comprising one or more "don't care" intervals and one or more "care" intervals;
- in the one or more "don't care" intervals, the components of the input audio signal (110) providing no contribution to the frequency components of the output audio signal (113);
- the allowed deviation of the frequency response (531, 532) taking on arbitrary or undefined values within the one or more "don't care" intervals and being unconstrained or undefined within the one or more "don't care" intervals;
- in the one or more "care" intervals, the frequency response (531, 532) of the filter (102) taking on a predetermined form;
- the perceptual frequency response being associated with a first perceptual frequency response indicative of a scaled and/or mirrored absolute threshold of hearing curve (505);
- the allowed deviation of the frequency response (531, 532) within the one or more "care" intervals being derived from the absolute threshold of hearing curve (505); and
- determining coefficients of the filter (102) such that the frequency response (531, 532) of the filter (102) is fitted to the allowed deviation of the frequency response (531, 532);
- the step of determining coefficients of the filter (102) comprising fitting the frequency response of the filter (102) to the allowed deviation of the frequency response (531, 532) outside of the one or more "don't care" intervals; while imposing no constraints on the frequency response of the filter (102) within the one or more "don't care" intervals.

**2.** The method of claim 1, wherein the step of determining coefficients of the filter (102) comprises fitting the frequency response of the filter (102) to the allowed deviation of the frequency response (531, 532) using a maximum absolute difference criteria or a least mean square criteria.

**3.** The method of claim 1, wherein the step of selecting an allowed deviation of the frequency response (531, 532) of the filter (102) within the stop band comprises:

- selecting the allowed deviation based on images and/or mirrored images of the first perceptual frequency response.

**4.** the method of any previous claim, wherein the perceptual frequency response is associated with a second perceptual frequency response comprising a scaled relative masking threshold curve (1100) indicative of the masking by a neighbouring frequency.

**5.** The method of any of claims 1 to 4, wherein the one or more "don't care" intervals comprise one or more second "don't care" intervals associated with frequencies for which the perceptual frequency response exceeds a pre-determined perceptual threshold.

**6.** The method of any previous claim, further comprising:

selecting a pass band edge and/or a stop band edge of the frequency response (531, 532) of the filter (102) based on the lower one of the input sampling rate ($fs_{in}$) and the output sampling rate ($fs_{out}$).

**7.** The method of any previous claim, further comprising:

- selecting a pass band edge and/or a stop band edge of the frequency response (531, 532) of the filter (102) based on a bandwidth of the input audio signal (110).

**8.** The method of any previous claim, further comprising:

limiting the allowed deviation of the frequency response (531, 532) of the filter (102) within the stop band, to avoid amplification of the input audio signal within the stop band.

**9.** A filter (102) configured to reduce imaging and/or aliasing of an output audio signal (113) at an output sampling rate ($fs_{out}$); wherein

- the output audio signal (113) is a resampled version of an input audio signal (110) at an input sampling rate ($fs_{in}$);
- the ratio of the output sampling rate ($fs_{out}$) and the input sampling rate ($fs_{in}$) is a rational number N/M;
- the filter (102) operates at an upsampled sampling rate which equals N times the input sampling rate ($fs_{in}$);
- the filter (102) comprises a pass band and a stop band;
- a frequency response of the filter (102) within the stop band is associated with a perceptual frequency response indicative of an auditory spectral sensitivity;
- the frequency response of the filter (102) within the stop band being selected by partitioning the stop band into a plurality of frequency intervals comprising one or more "don't care" intervals and one or more "care" intervals;
- in the one or more "don't care" intervals, the components of the input audio signal (110) providing no contribution to the frequency components of the output audio signal (113);
- the frequency response taking on arbitrary or undefined values within the one or more "don't care" intervals and being unconstrained or undefined within the one or more "don't care" intervals;
- in the one or more "care" intervals, the frequency response of the filter (102) taking on a pre-determined form;
- the perceptual frequency response being associated with a first perceptual frequency response indicative of a scaled and/or mirrored absolute threshold of hearing curve (505);
- the frequency response within the one or more "care" intervals being derived from the absolute threshold of hearing curve (505).

**10.** The filter (102) of claim 9, wherein the frequency response of the filter (102) within the stop band is associated with

- a second perceptual frequency response comprising a scaled relative masking threshold curve (1100) indicative of the masking by a neighbouring frequency.

**11.** The filter (102) of claim 10, wherein the frequency response of the filter (102) is fitted to the perceptual frequency response using a maximum absolute difference criteria or a least mean square criteria.

**12.** A method for resampling an input audio signal (110) at an input sampling rate ($fs_{in}$) to an output audio signal (113) at an output sampling rate ($fs_{out}$); wherein the ratio of the output sampling rate ($fs_{out}$) and the input sampling rate ($fs_{in}$) is a rational number N/M; the method comprising:

- providing a set of coefficients of a filter (102) according to any of claims 9 to 11 ;
- selecting a first subset of coefficients from the set of coefficients; wherein the first subset comprises a first coefficient of the set and coefficients of the set following the first coefficient by multiples of N; and
- determining a first sample of the output audio signal (113) based on the first subset of coefficients and a first plurality of samples of the input audio signal (110).

**13.** The method of claim 12 , further comprising:

- selecting a second coefficient of the set based on the first coefficient and M;
- selecting a second subset of coefficients from the set of coefficients; wherein the second subset comprises the second coefficient and coefficients of the set following the second coefficient by multiples of N; and
- determining a second sample of the output audio signal (113) directly following the first sample, based on the second subset of coefficients and a second plurality of samples of the input audio signal (110).

**14.** A resampler (100) configured to generate an output audio signal (113) at an output sampling rate ($fs_{out}$) from an input audio signal (110) at an input sampling rate ($fs_{in}$);
wherein the ratio of the output sampling rate ($fs_{out}$) and the input sampling rate ($fs_{in}$) is a rational number N/M; the resampler (100) comprising:

- a filter (102) according to any of claims 9 to 11; wherein the filter (102) comprises a set of coefficients;
- a coefficient selection unit configured to select a subset of coefficients from the set of coefficients; and
- a filtering unit configured to generate a sample of the output audio signal (113) from a plurality of samples of the input audio signal (110) using the subset of coefficients.

**15.** A software program adapted for execution on a processor and for performing the method steps of any of claims 1 to 8 or any of claims 12 to 13 when carried out on a computing device.

## Patentansprüche

**1.** Verfahren zum Entwerfen eines Filters (102), das konfiguriert ist, das Abbilden und/oder das Aliasing eines Ausgangsaudiosignals (113) mit einer Ausgangsabtastrate ($fs_{out}$) zu verringern; wobei das Ausgangsaudiosignal (113) eine Version mit geänderter Abtastrate eines Eingangsaudiosignals (110) mit einer Eingangsabtastrate ($fs_{in}$) ist; wobei das Verhältnis der Ausgangsabtastrate ($fs_{out}$) zu der Eingangsabtastrate ($fs_{in}$) eine rationale Zahl N/M ist; wobei das Filter (102) mit einer erhöhten Abtastrate arbeitet, die gleich der N-fachen Eingangsabtastrate ($fs_{in}$) ist; wobei das Verfahren Folgendes umfasst:

- Auswählen einer zulässigen Abweichung der Frequenzantwort (531, 532) des Filters (102) innerhalb eines Sperrbereichs des Filters (102) anhand einer wahrnehmbaren Frequenzantwort, die eine hörbare spektrale Empfindlichkeit angibt; wobei die zulässige Abweichung eine Abweichung der Frequenzantwort (531, 532) des Filters (102) von einer vorgegebenen Dämpfung innerhalb des Sperrbereichs angibt;
- wobei der Schritt des Auswählens der zulässigen Abweichung der Frequenzantwort (531, 532) des Filters (102) innerhalb des Sperrbereichs den Schritt des Unterteilens des Sperrbereichs in mehrere Frequenzintervalle, die ein oder mehrere "Don't care"-Intervalle und ein oder mehrere "Care"-Intervalle enthalten, umfasst;
- wobei in dem einen oder dem mehreren "Don't care"-Intervallen die Komponenten des Eingangsaudiosignals (110) keinen Beitrag zu den Frequenzkomponenten des Ausgangsaudiosignals (113) liefern;
- wobei die zulässige Abweichung der Frequenzantwort (531, 532) beliebige oder nicht definierte Werte innerhalb des einen oder der mehreren "Don't care"-Intervalle annimmt und innerhalb des einen oder der mehreren "Don't care"-Intervalle nicht beschränkt oder nicht definiert ist;
- wobei in dem einen oder den mehreren "Care"-Intervallen die Frequenzantwort (531, 532) des Filters (102) eine vorgegebene Form annimmt;
- wobei der wahrnehmbaren Frequenzantwort eine erste wahrnehmbare Frequenzantwort zugeordnet ist, die einen skalierten und/oder gespiegelten Absolut-Schwellenwert der Hörkurve (505) angibt;
- wobei die zulässige Abweichung der Frequenzantwort (531, 532) innerhalb des einen oder der mehreren "Care"-Intervalle von dem absoluten Schwellenwert der Hörkurve (505) abgeleitet wird; und
- Bestimmen von Koeffizienten des Filters (102) in der Weise, dass die Frequenzantwort (531, 532) des Filters (102) an die zulässige Abweichung der Frequenzantwort (531, 532) angepasst wird;
- wobei der Schritt des Bestimmens von Koeffizienten des Filters (102) das Anpassen der Frequenzantwort des Filters (102) an die zulässige Abweichung der Frequenzantwort (531, 532) außerhalb des einen oder der mehreren "Don't care"-Intervalle umfasst; während der Frequenzantwort des Filters (102) innerhalb des einen oder der mehreren "Don't care"-Intervalle keine Beschränkungen auferlegt werden.

**2.** Verfahren nach Anspruch 1, wobei der Schritt des Bestimmens von Koeffizienten des Filters (102) das Anpassen der Frequenzantwort des Filters (102) an die zulässige Abweichung der Frequenzantwort (531, 532) unter Verwendung eines Kriteriums der maximalen absoluten Differenz oder eines Kriteriums der kleinsten mittleren Quadrate umfasst.

**3.** Verfahren nach Anspruch 1, wobei der Schritt des Auswählens einer zulässigen Abweichung der Frequenzantwort (531, 532) des Filters (102) innerhalb des Sperrbereichs Folgendes umfasst:

- Auswählen der zulässigen Abweichung anhand von Bildern und/oder gespiegelten Bildern der ersten wahrnehmbaren Frequenzantwort.

**4.** Verfahren nach einem vorhergehenden Anspruch, wobei der wahrnehmbaren Frequenzantwort eine zweite wahrnehmbare Frequenzantwort zugeordnet ist, die eine skalierte relative Maskierungsschwellenkurve (1100), die die Maskierung durch eine Nachbarfrequenz angibt, enthält.

**5.** Verfahren nach einem der Ansprüche 1 bis 4, wobei das eine oder die mehreren "Don't care"-Intervalle einen oder mehrere zweite "Don't care"-Intervalle enthalten, denen Frequenzen zugeordnet sind, für die die wahrnehmbare Frequenzantwort einen vorgegebenen Wahrnehmungsschwellenwert überschreitet.

**6.** Verfahren nach einem vorhergehenden Anspruch, das ferner Folgendes umfasst:

Auswählen einer Durchlassband-Kante und/oder einer Sperrbereich-Kante der Frequenzantwort (531, 532) des Filters (102) anhand der niedrigeren der Eingangsabtastrate ($fs_{in}$) und der Ausgangsabtastrate ($fs_{out}$).

**7.** Verfahren nach einem vorhergehenden Anspruch, das ferner Folgendes umfasst:

- Auswählen einer Durchlassband-Kante und/oder einer Sperrbereich-Kante der Frequenzantwort (531, 532) des Filters (102) anhand einer Bandbreite des Eingangsaudiosignals (110).

**8.** Verfahren nach einem vorhergehenden Anspruch, das ferner Folgendes umfasst:

Beschränken der zulässigen Abweichung der Frequenzantwort (531, 532) des Filters (102) innerhalb des Sperrbereichs, um eine Verstärkung des Eingangsaudiosignals innerhalb des Sperrbereichs zu vermeiden.

**9.** Filter (102), das konfiguriert ist, das Abbilden und/oder das Aliasing eines Ausgangsaudiosignals (113) mit einer Ausgangsabtastrate ($fs_{out}$) zu verringern; wobei

- das Ausgangsaudiosignal (113) eine Version mit geänderter Abtastrate eines Eingangsaudiosignals (110) mit einer Eingangsabtastrate ($fs_{in}$) ist;
- das Verhältnis der Ausgangsabtastrate ($fs_{out}$) zu der Eingangsabtastrate ($fs_{in}$) eine rationale Zahl N/M ist;
- das Filter (102) mit einer erhöhten Abtastrate arbeitet, die gleich der N-fachen Eingangsabtastrate ($fs_{in}$) ist;
- das Filter (102) ein Durchlassband und einen Sperrbereich aufweist;
- eine Frequenzantwort des Filters (102) innerhalb des Sperrbereichs einer wahrnehmbaren Frequenzantwort zugeordnet ist, die eine hörbare spektrale Empfindlichkeit angibt;

- die Frequenzantwort des Filters (102) innerhalb des Sperrbereichs durch Unterteilen des Sperrbereichs in mehrere Frequenzintervalle, die einen oder mehrere "Don't care"-Intervalle und einen oder mehrere "Care"-Intervalle enthalten, ausgewählt wird;
- in dem einen oder den mehreren "Don't care"-Intervallen die Komponenten des Eingangsaudiosignals (110) keinen Beitrag zu den Frequenzkomponenten des Ausgangsaudiosignals (113) liefern;
- die Frequenzantwort beliebige oder nicht definierte Werte innerhalb des einen oder der mehreren "Don't care"-Intervalle annimmt und innerhalb des einen oder der mehreren "Don't care"-Intervalle nicht beschränkt oder nicht definiert ist;
- die Frequenzantwort des Filters (102) in dem einen oder den mehreren "Care"-Intervallen eine vorgegebene Form annimmt;
- der wahrnehmbaren Frequenzantwort eine erste wahrnehmbare Frequenzantwort zugeordnet ist, die einen skalierten und/oder gespiegelten absoluten Schwellenwert der Hörkurve (505) angibt;
- die Frequenzantwort in dem einen oder den mehreren "Care"-Intervallen von dem absoluten Schwellenwert der Hörkurve (505) abgeleitet wird.

**10.** Filter (102) nach Anspruch 9, wobei der Frequenzantwort des Filters (102) innerhalb des Sperrbereichs Folgendes zugeordnet ist:

- eine zweite wahrnehmbare Frequenzantwort, die eine skalierte relative Maskierungsschwellenkurve (1100) enthält, die die Maskierung durch eine Nachbarfrequenz angibt.

**11.** Filter (102) nach Anspruch 10, wobei die Frequenzantwort des Filters (102) an die wahrnehmbare Frequenzantwort unter Verwendung eines Kriteriums der maximalen absoluten Differenz oder eines Kriteriums der kleinsten mittleren Quadrate angepasst wird.

**12.** Verfahren zum Ändern der Abtastrate eines Eingangsaudiosignals (110) mit einer Eingangsabtastrate ($fs_{in}$) in ein Ausgangsaudiosinal (113) mit einer Ausgangsabtastrate ($fs_{out}$); wobei das Verhältnis der Ausgangsabtastrate ($fs_{out}$) zu der Eingangsabtastrate ($fs_{in}$) eine rationale Zahl N/M ist; wobei das Verfahren Folgendes umfasst:

- Bereitstellen einer Menge von Koeffizienten eines Filters (102) nach einem der Ansprüche 9 bis 11;
- Auswählen einer ersten Untermenge von Koeffizienten aus der Menge von Koeffizienten; wobei die erste Untermenge einen ersten Koeffizienten der Menge und Koeffizienten der Menge, die dem ersten Koeffizienten in Vielfachen von N folgen, enthält; und
- Bestimmen eines ersten Abtastwerts des Ausgangsaudiosignal (113) anhand der ersten Untermenge von Koeffizienten und einer ersten Mehrzahl von Abtastwerten des Eingangsaudiosignals (110).

**13.** Verfahren nach Anspruch 12, das ferner Folgendes umfasst:

- Auswählen eines zweiten Koeffizienten der Menge anhand des ersten Koeffizienten und von M;
- Auswählen einer zweiten Untermenge von Koeffizienten aus der Menge von Koeffizienten; wobei die zweite Untermenge den zweiten Koeffizienten und Koeffizienten der Menge, die dem zweiten Koeffizienten in Vielfachen von N folgen, enthält; und
- Bestimmen eines zweiten Abtastwerts des Ausgangsaudiosignals (113), der dem ersten Abtastwert direkt folgt, anhand der zweiten Untermenge von Koeffizienten und einer zweiten Mehrzahl von Abtastwerten des Eingangsaudiosignals (110).

**14.** Abtastratenänderungseinrichtung (100), die konfiguriert ist, aus einem Eingangsaudiosignal (110) mit einer Eingangsabtastrate ($fs_{in}$) ein Ausgangsaudiosignal (113) mit einer Ausgangsabtastrate ($fs_{out}$) zu erzeugen; wobei das Verhältnis der Ausgangsabtastrate ($fs_{out}$) zu der Eingangsabtastrate ($fs_{in}$) eine rationale Zahl N/M ist; wobei die Abtastratenänderungseinrichtung (100) Folgendes umfasst:

- ein Filter (102) nach einem der Ansprüche 9 bis 11; wobei das Filter (102) eine Menge von Koeffizienten enthält;
- eine Koeffizientenauswahleinheit, die konfiguriert ist, eine Untermenge von Koeffizienten aus der Menge von Koeffizienten auszuwählen; und
- eine Filterungseinheit, die konfiguriert ist, einen Abtastwert des Ausgangsaudiosignals (113) aus mehreren Abtastwerten des Eingangsaudiosignals (110) unter Verwendung der Untermenge von Koeffizienten zu erzeugen.

15. Software-Programm, das dafür ausgelegt ist, in einem Prozessor ausgeführt zu werden und die Verfahrensschritte nach einem der Ansprüche 1 bis 8 oder nach einem der Ansprüche 12 bis 13 auszuführen, wenn es in einer Rechenvorrichtung ausgeführt wird.

## Revendications

1. Procédé de conception d'un filtre (102) configuré pour réduire l'imagerie et/ou le crénelage d'un signal audio de sortie (113) à une cadence d'échantillonnage de sortie ($fS_{out}$) ; le signal audio de sortie (113) étant une version rééchantillonnée d'un signal audio d'entrée (110) à une cadence d'échantillonnage d'entrée ($fS_{in}$) ;
dans lequel le rapport de la cadence d'échantillonnage de sortie ($fS_{out}$) sur la cadence d'échantillonnage d'entrée ($fS_{in}$) est un nombre rationnel N/M ;
dans lequel le filtre (102) fonctionne à une cadence d'échantillonnage surchantillonnée égale à N fois la cadence d'échantillonnage d'entrée ($fS_{in}$) ;
le procédé comprenant :

    - la sélection d'un écart autorisé de la réponse de fréquence (531, 532) du filtre (102) dans une bande d'arrêt du filtre (102) en fonction d'une réponse de fréquence perceptuelle indicative d'une sensibilité spectrale auditive ; dans lequel l'écart autorisé indique un écart de la réponse de fréquence (531, 532) du filtre (102) par rapport à une atténuation prédéterminée dans la bande d'arrêt ;
    - l'étape de sélection de l'écart autorisé de la réponse de fréquence (531, 532) du filtre (102) dans la bande d'arrêt comprenant l'étape de sectionnement de la bande d'arrêt en une pluralité d'intervalles de fréquence comprenant un ou plusieurs intervalles "non pertinents" et un ou plusieurs intervalles "pertinents" ;
    - dans les un ou plusieurs intervalle "non pertinents", les composantes du signal audio d'entrée (110) ne contribuant en rien aux composantes de fréquence du signal audio de sortie (113) ;
    - l'écart autorisé de la réponse de fréquence (531, 532) prenant des valeurs arbitraires ou indéfinies dans les un ou plusieurs intervalles "non pertinents" et étant libre ou indéfini dans les un ou plusieurs intervalles "non pertinents" ;
    - dans les un ou plusieurs intervalles "pertinents", la réponse de fréquence (531, 532) du filtre (102) prenant une forme prédéterminée ;
    - la réponse de fréquence perceptuelle étant associée à une première réponse de fréquence perceptuelle indicative d'un seuil absolu dimensionné et/ou miroir d'une courbe d'audition (505) ;
    - l'écart autorisé de la réponse de fréquence (531, 532) dans les un ou plusieurs intervalles "pertinents" étant dérivé du seuil absolu de la courbe d'audition (505) ; et
    - la détermination de coefficients du filtre (102) de telle sorte que la réponse de fréquence (531, 532) du filtre (102) soit ajustée à l'écart autorisé de la réponse de fréquence (531, 532) ;
    - l'étape de détermination de coefficients du filtre (102) comprenant l'ajustement de la réponse de fréquence du filtre (102) à l'écart autorisé de la réponse de fréquence (531, 532) en dehors un ou plusieurs intervalles "non pertinents" ; sans imposer de contrainte à la réponse de fréquence du filtre (102) dans les un ou plusieurs intervalles "non pertinents".

2. Procédé selon la revendication 1, dans lequel l'étape de détermination de coefficients du filtre (102) comprend l'ajustement de la réponse de fréquence du filtre (102) à l'écart autorisé de la réponse de fréquence (531, 532) en utilisant un critère de différence absolue maximum ou au moins un critère des moindres carrés.

3. Procédé selon la revendication 1, dans lequel l'étape de sélection d'un écart autorisé de la réponse de fréquence (531, 532) du filtre (102) dans la bande d'arrêt comprend :

    - la sélection de l'écart autorisé en fonction d'images et/ou d'images miroirs de la première réponse de fréquence perceptuelle.

4. Procédé selon l'une quelconque des revendications précédentes, dans lequel la réponse de fréquence perceptuelle est associée à une seconde réponse de fréquence perceptuelle comprenant une courbe de seuil de masquage relatif dimensionné (1100) indicative du masquage par une fréquence voisine.

5. Procédé selon l'une quelconque des revendications 1 à 4, dans lequel les un ou plusieurs intervalles "non pertinents" comprennent un ou plusieurs seconds intervalles "non pertinents" associés à des fréquences pour lesquelles la réponse de fréquence perceptuelle dépasse un seuil perceptif prédéterminé.

**6.** Procédé selon l'une quelconque des revendications précédentes, comprenant en outre :

la sélection d'un bord de bande passante et/ou d'un bord de bande d'arrêt de la réponse de fréquence (531, 532) du filtre (102) en fonction de la cadence la plus basse entre la cadence d'échantillonnage d'entrée ($fS_{in}$) et la cadence d'échantillonnage de sortie ($fS_{out}$).

**7.** Procédé selon l'une quelconque des revendications précédentes, comprenant en outre :

- la sélection d'un bord de bande passante et/ou d'un bord de bande d'arrêt de la réponse de fréquence (531, 532) du filtre (102) en fonction d'une largeur de bande du signal audio d'entrée (110).

**8.** Procédé selon l'une quelconque des revendications précédentes, comprenant en outre :

la limitation de l'écart autorisé de la réponse de fréquence (531, 532) du filtre (102) dans ma bande d'arrêt, pour éviter l'amplification du signal audio d'entrée dans la bande d'arrêt.

**9.** Filtre (102) configuré pour réduire l'imagerie et/ou le crénelage d'un signal audio de sortie (113) à une cadence d'échantillonnage de sortie ($fS_{out}$) ; dans lequel

- le signal audio de sortie (113) est une version rééchantillonnée d'un signal audio d'entrée (110) à une cadence d'échantillonnage d'entrée ($fS_{in}$) ;
- le rapport de la cadence d'échantillonnage de sortie ($fS_{out}$) sur la cadence d'échantillonnage d'entrée ($fS_{in}$) est un nombre rationnel N/M ;
- le filtre (102) fonctionne à une cadence d'échantillonnage surchantillonnée qui est égale à N fois la cadence d'échantillonnage d'entrée ($fS_{in}$) ;
- le filtre (102) comprend une bande passante et une bande d'arrêt ;
- une réponse de fréquence du filtre (102) dans la bande d'arrêt est associée à une réponse de fréquence perceptuelle indicative d'une sensibilité spectrale auditive ;
- la réponse de fréquence du filtre (102) dans la bande d'arrêt étant sélectionnée par sectionnement de la bande d'arrêt en une pluralité d'intervalles de fréquence comprenant un ou plusieurs intervalles "non pertinents" et un ou plusieurs intervalles "pertinents" ;
- dans les un ou plusieurs intervalles "non pertinents", les composantes du signal audio d'entrée (110) ne contribuant en rien aux composantes de fréquence du signal audio de sortie (113) ;
- la réponse de fréquence prenant des valeurs arbitraires ou indéfinies dans les un ou plusieurs intervalles "non pertinents" et étant libre ou indéfinie dans les un ou plusieurs intervalles "non pertinents" ;
- dans les un ou plusieurs intervalles "pertinents", la réponse de fréquence du filtre (102) prenant une forme prédéterminée ;
- la réponse de fréquence perceptuelle étant associée à une première réponse de fréquence perceptuelle indicative d'un seuil absolu dimensionné et/ou reproduit d'une courbe d'audition (505) ;
- la réponse de fréquence dans les un ou plusieurs intervalles "pertinents" étant dérivée du seuil absolu de la courbe d'audition (505).

**10.** Filtre (102) selon la revendication 9, dans lequel la réponse de fréquence du filtre (102) dans la bande d'arrêt est associée à

- une seconde réponse de fréquence perceptuelle comprenant une courbe à seuil de masquage relatif dimensionnée (1100) indicative du masquage par une fréquence voisine.

**11.** Filtre (102) selon la revendication 10, dans lequel la réponse de fréquence du filtre (102) est ajustée à la réponse de fréquence perceptuelle en utilisant un critère de différence absolue maximum ou au moins un critère des moindres carrés.

**12.** Procédé de rééchantillonnage d'un signal audio d'entrée (110) à une cadence d'échantillonnage d'entrée ($fS_{in}$) pour produire un signal audio de sortie (113) à une cadence d'échantillonnage de sortie ($fS_{out}$) ; dans lequel le rapport de la cadence d'échantillonnage de sortie ($fS_{out}$) sur la cadence d'échantillonnage d'entrée ($fS_{in}$) est un nombre rationnel N/M ; le procédé comprenant :

la fourniture d'un ensemble de coefficients d'un filtre (102) selon l'une quelconque des revendications 9 à 11 ;

- la sélection d'un premier sous-ensemble de coefficients parmi l'ensemble de coefficients ; dans lequel le premier sous-ensemble comprend un premier coefficient de l'ensemble et des coefficients de l'ensemble suivant le premier coefficient par des multiples de N ; et
- la détermination d'un premier échantillon du signal audio de sortie (113) en fonction du premier sous-ensemble de coefficients et d'une première pluralité d'échantillons du signal audio d'entrée (110).

**13.** Procédé selon la revendication 12, comprenant en outre :

- la sélection d'un second coefficient de l'ensemble en fonction du premier coefficient et de M :
- la sélection d'un second sous-ensemble de coefficients parmi l'ensemble de coefficients ; dans lequel le second sous-ensemble comprend le second coefficient et des coefficients de l'ensemble suivant le second coefficient par des multiples de N ; et
- la détermination d'un second échantillon du signal audio de sortie (113) suivant directement le premier échantillon, en fonction du second sous-ensemble de coefficients et d'une seconde pluralité d'échantillons du signal audio d'entrée (110).

**14.** Rééchantillonneur (100) configuré pour générer un signal audio de sortie (113) à une cadence d'échantillonnage de sortie ($fS_{out}$) à partir d'un signal audio d'entrée (110) à une cadence d'échantillonnage d'entrée ($fS_{in}$) ;
dans lequel le rapport de la cadence d'échantillonnage de sortie ($fS_{out}$) sur la cadence d'échantillonnage d'entrée ($fS_{in}$) est un nombre rationnel N/M ; le rééchantillonneur (100) comprenant :

- un filtre (102) selon l'une quelconque des revendications 9 à 11 ; le filtre (102) comprenant un ensemble de coefficients ;
- une unité de sélection de coefficients configurée pour sélectionner un sous-ensemble de coefficients à partir de l'ensemble de coefficients ; et
- une unité de filtrage configurée pour générer un échantillon du signal audio de sortie (113) à partir d'une pluralité d'échantillons du signal audio d'entrée (110) en utilisant le sous-ensemble de coefficients.

**15.** Programme logiciel adapté en vue de son exécution sur un processeur et pour exécuter les étapes de procédé selon l'une quelconque des revendications 1 à 8 ou l'une quelconque des revendications 12 à 13, à son exécution sur un dispositif informatique.

110
111
112
113
100
↑n
Filter with ℋ
↓m
101
102
103

Fig. 1

201
202
204
206
200
203
205
Magnitude (dB)
Frequency (kHz)
0
-50
-100
-150
-200
-250
-300
-350
0
20
40
60
80
100
120

Fig. 2

300
Bifrequency Plot
24
23
22
21
20
19
18
17
16
15
14
13
12
11
10
9
8
7
6
5
4
3
2
1
0
0 1 2 3 4 5 6 7 8 9 10 11 12 13 14 15 16 17 18 19 20
fs_out [kHz]
fs_in [kHz]
316
315
314
313
312
311
310
320
321
322
323
324
325

FIG. 3

400
Bifrequency Plot
401
24
23
22
21
20
19
18
17
16
15
14
13
12
11
10
9
8
7
6
5
4
3
2
1
0
fs_out [kHz]
0 1 2 3 4 5 6 7 8 9 10 11 12 13 14 15 16 17 18 19 20
fs_in [kHz]

FIG. 4A

410
Care / Don't Care
1.5
1
0.5
0
411
412
415
413
416
414
417
0
20
40
60
80
100
120
420
[dB]
0
-10
-20
-30
421
430
431
425
426
427
[kHz]

FIG. 4B

Threshold of Hearing [dB (re. 20 μPa)]
200
180
160
140
120
100
80
60
40
20
0
-20
Frequency [Hz]
10
100
1000
10000
100000
505
506
507

*FIG. 5A*

500
507
Bifrequency Plot
24
23
22
21
20
19
18
17
16
15
14
13
12
11
10
9
8
7
6
5
4
3
2
1
0
fs_out [kHz]
0 1 2 3 4 5 6 7 8 9 10 11 12 13 14 15 16 17 18 19 20
fs_in [kHz]
506

*FIG. 5B*

410
Care / Don't Care
1.5
1
0.5
0
411
412
415
413
416
414
417
0
20
40
60
80
100
120
520
[dB]
0
-50
-100
430
531
528
532
529
525-1
525-2
525-3
523
[kHz]

FIG. 5C

[dB]
0
-20
-40
-60
-80
-100
-120
0
20
40
60
80
100
120
[kHz]
601
611

FIG. 6

700
x 10^4
Frequency (Hz)
2
1.5
1
0.5
0
1
2
3
4
5
6
7
8
9
Time
701
702

*FIG. 7*

0.5
0.4
0.3
0.2
0.1
0
abs (floor(x+1/2)-x)
-2
-1.5
-1
-0.5
0
0.5
1
1.5
2
V

FIG. 8

900
120 kHz
72 kHz
24 kHz
20 kHz
80 kHz
914
64 kHz
921
913
108 kHz
60 kHz
40 kHz
912
88 kHz
911
44 kHz
100 kHz
901
0 kHz
48 kHz
96 kHz
Aliases [kHz]
0
5
10
15
20
Baseband [kHz]

FIG. 9

0
-20
-40
-60
-80
-100
-120
[dB]
0
6
12
18
24
[kHz]

*FIG. 10*

25
20
15
10
5
0
f [Bark]
0
5000
10000
15000
20000
f [Hz]

FIG. 11A

0
-10
-20
-30
-40
-50
-60
-70
-80
Masking Threshold [dB]
1100
-2
-1
0
1
2
3
4
5
6
Delta f [Bark]

FIG. 11B

ath
Self Masking
Masking Threshold [dB]
0
-20
-40
-60
-80
-100
0
20000
40000
60000
80000
100000
120000
f [Hz]
1111
1112
1113
1114
1115
1101
1102
1103
1104

FIG. 11C

[dB]
0
-20
-40
-60
-80
-100
-120
0
20
40
60
80
100
120
[kHz]
1202
1201

FIG. 12

1300
Selecting a Cut-off Frequency
1301
Selecting a Pass Band
1302
Identifying "Don't Care" Intervals of the Stop Band
1303
Assigning Images or Mirrored Images of a Perceptual Frequency Response to the Stop Band
1304
Determining the Coefficients of the Filter Such That Its Frequency Response is Fitted to the Target Frequency Response
1305

FIG. 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- EP 1622264 A
- US 5222189 A


### Non-patent literature cited in the description


- **T.PARKS ; J.MCCLELLAN.** Chebyshev Approximation for Nonrecursive Digital Filters with Linear Phase. *IEEE Transactions on Circuit Theory,* March 1972, vol. CT-19 (2